# EUROPEAN PATENT SPECIFICATION

(11) **EP 4 255 157 B1**
(45) Date of publication and mention of the grant of the patent: **01.07.2026**
(21) Application number: 23160329.1
(22) Date of filing: 07.03.2023
(51) Int. Cl.: H10N 30/076, H10N 30/00, H10N 30/853, H10N 30/87, B06B 1/02, B06B 1/06, G01H 11/08

(54) **PIEZOELECTRIC FILM INTEGRATED DEVICE, MANUFACTURING METHOD THEREOF, AND ACOUSTIC OSCILLATION SENSOR**
INTEGRIERTE PIEZOELEKTRISCHE DÜNNSCHICHTVORRICHTUNG, HERSTELLUNGSVERFAHREN DAFÜR UND AKUSTISCHER OSZILLATIONSSENSOR
DISPOSITIF INTÉGRÉ À FILM PIÉZOÉLECTRIQUE, SON PROCÉDÉ DE FABRICATION ET CAPTEUR D'OSCILLATION ACOUSTIQUE

(30) Priority: 30.03.2022 JP 2022055799
(43) Date of publication of application: 04.10.2023
(73) Proprietor: Oki Electric Industry Co., Ltd., Minato-ku Tokyo 105-8460 (JP); I-PEX Piezo Solutions Inc., Ube-shi, Yamaguchi 755-0152 (JP)
(72) Inventor: FURUTA, Hironori, Tokyo, 105-8460 (JP); KOSAKA, Toru, Tokyo, 105-8460 (JP); SUZUKI, Takahito, Tokyo, 105-8460 (JP); TANIGAWA, Kenichi, Tokyo, 105-8460 (JP); ISHIKAWA, Takuma, Tokyo, 105-8460 (JP); KITAJIMA, Yutaka, Tokyo, 105-8460 (JP); KONISHI, Akio, Ube-shi, 755-0152 (JP); KANAMORI, Hiroaki, Ube-shi, 755-0152 (JP); IIZUKA, Takeshi, Ube-shi, 755-0152 (JP)
(74) Representative: Betten & Resch

(56) References cited:
- CN-A- 113 574 690
- JP-A- 2021 166 220
- US-A1- 2020 055 088

## Description

### BACKGROUND OF THE INVENTION

### 1. Field of the Invention

The present disclosure relates to a piezoelectric film integrated device, a manufacturing method thereof, and an acoustic oscillation sensor.

### 2. Description of the Related Art

Conventionally, there has been disclosed an ultrasonic sensor configured by forming polycrystalline piezoelectric films of different types on the same substrate. See Japanese Patent Application Publication No. 2021-166220 (Patent Reference 1), for example).

A similar device can be found in US 2020/055088 A1.

However, a high-performance piezoelectric film integrated device cannot be obtained when a plurality of polycrystalline piezoelectric films are arranged on the same substrate in a conventional device.

### SUMMARY OF THE INVENTION

An object of the present disclosure is to provide a high-performance piezoelectric film integrated device in which monocrystalline piezoelectric films of two or more types are provided on the same substrate, a manufacturing method thereof, and an acoustic oscillation sensor including the piezoelectric film integrated device.

A piezoelectric film integrated device according to the present disclosure includes a substrate, a first electrode provided on the substrate, a second electrode provided on the substrate, a first monocrystalline piezoelectric film provided on the first electrode, a second monocrystalline piezoelectric film provided on the second electrode and having a crystal structure different from a crystal structure of the first monocrystalline piezoelectric film, a third electrode provided on the first monocrystalline piezoelectric film, and a fourth electrode provided on the second monocrystalline piezoelectric film.

According to the present disclosure, by providing monocrystalline piezoelectric films of two or more types on the same substrate, the performance of the piezoelectric film integrated device and the acoustic oscillation sensor can be increased.

### BRIEF DESCRIPTION OF THE DRAWINGS

The present disclosure will become more fully understood from the detailed description given hereinbelow and the accompanying drawings which are given by way of illustration only, and wherein:
Fig. 1 is a side view schematically showing the structure of a piezoelectric film integrated device according to a first embodiment;
Fig. 2 is a top view schematically showing the structure of the piezoelectric film integrated device in Fig. 1;
Fig. 3 is a cross-sectional view of the piezoelectric film integrated device in Fig. 2 taken along the line S3-S3;
Fig. 4 is a bottom view schematically showing the structure of the piezoelectric film integrated device in Fig. 1;
Fig. 5 is a cross-sectional view schematically showing the structure of an epitaxial growth film including a monocrystalline PZT film as a monocrystalline piezoelectric film;
Fig. 6 is a diagram showing the crystal structure of the monocrystalline PZT film in Fig. 5;
Fig. 7 is a diagram schematically showing the crystal structure of the epitaxial growth film in Fig. 5;
Fig. 8 is a cross-sectional view schematically showing the structure of the epitaxial growth film including a monocrystalline AlN film as a monocrystalline piezoelectric film;
Fig. 9A is a diagram schematically showing a (111)-surface of a crystal of each of a monocrystalline SRO film, monocrystalline Pt and monocrystalline ZrO₂ in Fig. 8, and Fig. 9B is a diagram showing a lattice constant of the crystal of monocrystalline SRO;
Fig. 10A is a diagram schematically showing the crystal structure of the monocrystalline AlN film in Fig. 8, and Fig. 10B is a diagram showing the lattice constant of the crystal of monocrystalline AlN;
Fig. 11 is a flowchart showing a method of manufacturing the piezoelectric film integrated device in Fig. 1;
Figs. 12A and 12B are a cross-sectional view and a top view schematically showing the structure of a first electrode and a second electrode in step ST102 in Fig. 11;
Figs. 13A and 13B are a top view and a cross-sectional view schematically showing the structure of a first epitaxial growth film in step ST103 in Fig. 11;
Figs. 14A and 14B are a top view and a cross-sectional view schematically showing the structure of the first epitaxial growth film in step ST104 in Fig. 11;
Fig. 15 is a cross-sectional view schematically showing a holding process of the first epitaxial growth film in step ST105 in Fig. 11;
Fig. 16 is a cross-sectional view schematically showing an etching process of a sacrificial layer in the step ST105 in Fig. 11;
Figs. 17A and 17B are a top view and a cross-sectional view schematically showing the structure of a second epitaxial growth film in step ST106 in Fig. 11;
Figs. 18A and 18B are a top view and a cross-sectional view schematically showing the structure of the second epitaxial growth film in step ST107 in Fig. 11;
Fig. 19 is a cross-sectional view schematically showing a holding process of the second epitaxial growth film in step ST108 in Fig. 11;
Fig. 20 is a cross-sectional view schematically showing an etching process of a sacrificial layer in the step ST108 in Fig. 11;
Fig. 21 is a cross-sectional view schematically showing a sticking process of the first epitaxial growth film and the second epitaxial growth film in step ST109 in Fig. 11;
Fig. 22 is a cross-sectional view schematically showing the structure of the piezoelectric film integrated device in step ST110 in Fig. 11;
Fig. 23 is a diagram showing a crystal c-axis of the monocrystalline PZT film as a first monocrystalline piezoelectric film and a crystal c-axis of the monocrystalline AlN film as a second monocrystalline piezoelectric film;
Fig. 24 is a diagram schematically showing the configuration of an acoustic oscillation sensor employing a semiconductor integrated device according to the first embodiment;
Fig. 25 is a diagram showing a principle of operation of the acoustic oscillation sensor;
Fig. 26 is a side view schematically showing the structure of a piezoelectric film integrated device according to a modification of the first embodiment;
Fig. 27 is a top view schematically showing the structure of the piezoelectric film integrated device in Fig. 26;
Fig. 28 is a cross-sectional view of the piezoelectric film integrated device in Fig. 27 taken along the line S28-S28;
Fig. 29 is a bottom view schematically showing the structure of the piezoelectric film integrated device in Fig. 26;
Fig. 30 is a side view schematically showing the structure of a piezoelectric film integrated device according to a second embodiment;
Fig. 31 is a top view schematically showing the structure of the piezoelectric film integrated device in Fig. 30;
Fig. 32 is a cross-sectional view of the piezoelectric film integrated device in Fig. 31 taken along the line S32-S32;
Fig. 33 is a flowchart showing a method of manufacturing the piezoelectric film integrated device in Fig. 30;
Fig. 34 is a cross-sectional view schematically showing the structure of a first epitaxial growth film in step ST202 in Fig. 33;
Fig. 35 is a cross-sectional view schematically showing the structure of the first epitaxial growth film (individual piece) in step ST203 in Fig. 33;
Fig. 36 is a cross-sectional view schematically showing the structure of the first epitaxial growth film (individual piece) and a second epitaxial growth film (individual piece) in step ST208 in Fig. 33;
Fig. 37 is a cross-sectional view schematically showing the structure of the piezoelectric film integrated device in step ST209 in Fig. 33;
Fig. 38 is a side view schematically showing the structure of a piezoelectric film integrated device according to a third embodiment;
Fig. 39 is a top view schematically showing the structure of the piezoelectric film integrated device in Fig. 38;
Fig. 40 is a cross-sectional view of the piezoelectric film integrated device in Fig. 39 taken along the line S40-S40;
Fig. 41 is a flowchart showing a method of manufacturing the piezoelectric film integrated device in Fig. 38;
Fig. 42 is a cross-sectional view schematically showing the structure of a second epitaxial growth film in step ST302 in Fig. 41;
Fig. 43 is a cross-sectional view schematically showing the structure of the second epitaxial growth film (individual piece) in step ST303 in Fig. 41;
Fig. 44 is a cross-sectional view schematically showing the structure of a first epitaxial growth film (individual piece) and the second epitaxial growth film (individual piece) in step ST308 in Fig. 41;
Fig. 45 is a cross-sectional view schematically showing the structure of the piezoelectric film integrated device in step ST309 in Fig. 41;
Fig. 46 is a cross-sectional view schematically showing the structure of an epitaxial growth film including the monocrystalline PZT film;
Fig. 47 is a cross-sectional view schematically showing the structure of an epitaxial growth film including the monocrystalline AlN film
Fig. 48 is a cross-sectional view schematically showing the structure of a piezoelectric film integrated device according to a first modification of the first embodiment; and
Fig. 49 is a top view schematically showing the structure of the piezoelectric film integrated device in Fig. 48.

### DETAILED DESCRIPTION OF THE INVENTION

A piezoelectric film integrated device, a manufacturing method thereof, and an acoustic oscillation sensor according to each embodiment will be described below with reference to the drawings. The following embodiments are just examples and a variety of modifications are possible within the scope of the present disclosure. In the present application, the piezoelectric film integrated device is a device in which two or more monocrystalline piezoelectric films are provided on the same substrate. Further, in the present application, the acoustic oscillation sensor is a sensor that detects status (e.g., distance, shape, movement or the like) of a detection target object by outputting an acoustic oscillatory wave and detecting reflected waves of the acoustic oscillatory wave. The acoustic oscillation sensor is referred to also as an "ultrasonic sensor". In general, and in the present application, the acoustic oscillatory wave is made up of at least one of a sonic wave and an ultrasonic wave. Namely, the acoustic oscillatory wave includes a sonic wave, an ultrasonic wave, or both of a sonic wave and an ultrasonic wave.

### (1) First Embodiment

### (1-1) Structure of Piezoelectric Film Integrated Device 100

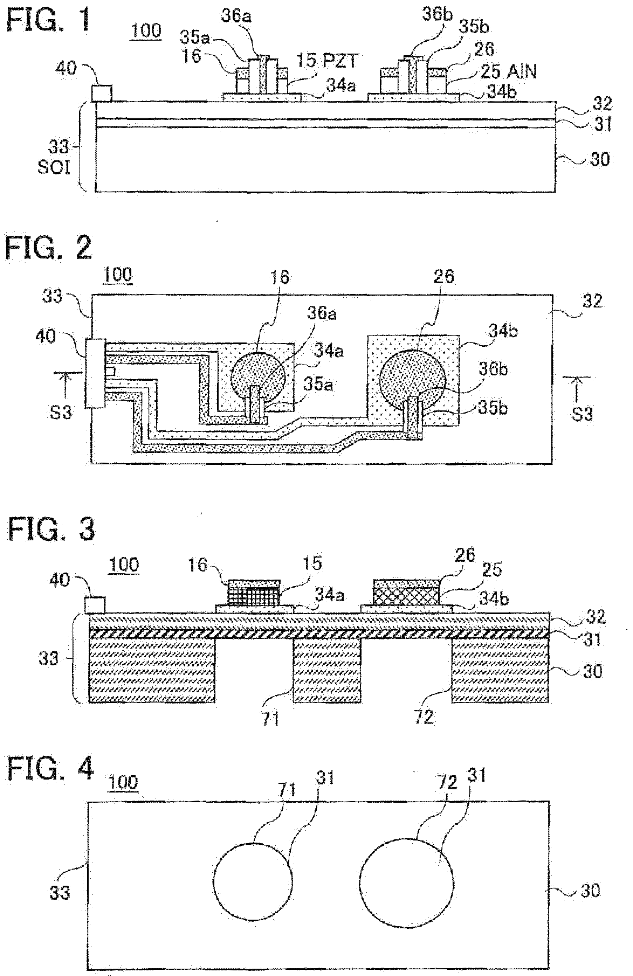

Fig. 1 is a side view schematically showing the structure of a piezoelectric film integrated device 100 according to a first embodiment. Fig. 2 is a top view schematically showing the structure of the piezoelectric film integrated device 100. Fig. 3 is a cross-sectional view of the piezoelectric film integrated device 100 in Fig. 2 taken along the line S3-S3. Fig. 4 is a bottom view schematically showing the structure of the piezoelectric film integrated device 100.

The piezoelectric film integrated device 100 includes an SOI substrate 33 as a substrate, a platinum (Pt) film 34a as a first electrode provided on the SOI substrate 33, and a Pt film 34b as a second electrode provided on the SOI substrate 33. As shown in Fig. 2, the Pt films 34a and 34b are connected to a connector 40 via a wiring layer formed on the SOI substrate 33. The SOI stands for Silicon On Insulator. Further, in the SOI substrate 33, there may be formed a drive circuit for driving the piezoelectric film integrated device 100 and thereby generating the acoustic oscillatory wave, a processing circuit that executes a process by using an acoustic oscillatory wave detection signal, and so forth.

The piezoelectric film integrated device 100 includes a monocrystalline PZT film 15 as a first monocrystalline piezoelectric film provided on the Pt film 34a and a monocrystalline AlN film 25 as a second monocrystalline piezoelectric film having a crystal structure different from a crystal structure of the first monocrystalline piezoelectric film and provided on the Pt film 34b. The PZT represents piezoelectric zirconate titanate (lead zirconate titanate). The AlN represents aluminum nitride. As the first monocrystalline piezoelectric film, instead of the monocrystalline PZT film 15, a piezoelectric film made of a different monocrystalline material such as a monocrystalline potassium sodium niobate (monocrystalline KNN) film or a monocrystalline barium titanate (monocrystalline BaTiO₃) film may be used. As the second monocrystalline piezoelectric film, instead of the monocrystalline AlN film 25, a piezoelectric film made of a different monocrystalline material such as a monocrystalline lithium tantalate (monocrystalline LiTaO₃) film or a monocrystalline lithium niobate (monocrystalline LiNbO₃) film may be used. The first monocrystalline piezoelectric film is a piezoelectric body that generates the acoustic oscillatory wave, and is desired to be a piezoelectric body capable of obtaining oscillation amplitude greater than oscillation amplitude of the second monocrystalline piezoelectric film. The second monocrystalline piezoelectric film is a piezoelectric body that detects the acoustic oscillatory wave (or its reflected waves), and is desired to be a piezoelectric body having detection sensitivity higher than detection sensitivity of the first monocrystalline piezoelectric film.

Further, the piezoelectric film integrated device 100 includes a Pt film 16 as a third electrode provided on the monocrystalline PZT film 15 and a Pt film 26 as a fourth electrode provided on the monocrystalline AlN film 25. Furthermore, the piezoelectric film integrated device 100 includes insulation films 35a and 35b and wiring films 36a and 36b formed on the insulation films 35a and 35b.

The SOI substrate 33 includes a Si substrate 30, a silicon dioxide (SiO₂) part 31 as an insulation film, and a monocrystalline silicon (monocrystalline Si) part 32. A cavity 71 and a cavity 72 are formed by etching the Si substrate 30 in regions of the SiO₂ part 31 and the monocrystalline silicon (monocrystalline Si) part 32 under the monocrystalline PZT film 15 and the monocrystalline AlN film 25 (i.e., regions respectively overlapping with the piezoelectric films), and the SiO₂ part 31 and the monocrystalline silicon (monocrystalline Si) part 32 situated in the regions where the cavities 71 and 72 are formed have a function as a vibrating plate. Further, variations in the thickness of the vibrating plate due to influence of the etching can be prevented by forming the silicon dioxide (SiO₂) part 31 made of a material different from the Si substrate 30 and giving the silicon dioxide (SiO₂) part 31 a function as an etching stop layer. As the substrate, a substrate made of a different material such as a glass substrate or an organic film substrate may also be used instead of the SOI substrate 33. In the Si substrate 30 of the SOI substrate 33, the cavities 71 and 71 that expose the SiO₂ part 31 are formed. The cavities 71 and 72 are formed in circular shapes as opening shapes respectively corresponding to the shapes of the monocrystalline PZT film 15 and the monocrystalline AlN film 25. The acoustic oscillatory wave generated by the monocrystalline PZT film 15 is outputted through the cavity 71, and the monocrystalline AlN film 25 detects reflected waves of the acoustic oscillatory wave through the cavity 72.

The monocrystalline PZT film 15 is an epitaxial growth film having a (001)-surface as a crystal face parallel to a surface of the Pt film 34a and being stuck (or bonded) on the surface of the Pt film 34a. The monocrystalline AlN film 25 is an epitaxial growth film having a (0001)-surface as a crystal face parallel to a surface of the Pt film 34b and being stuck (or bonded) on the surface of the Pt film 34b. The thickness of the monocrystalline PZT film 15 is generally in a range of 10 nm to 10 µm, and preferably in a range of 100 nm to 5 µm. The thickness of the monocrystalline AlN film 25 is generally in a range of 10 nm to 10 µm, and preferably in a range of 100 nm to 2 µm. The Pt film 34a and the Pt film 34b are formed on an upper surface of the same SOI substrate 33. The surface of the Pt film 34a and the surface of the Pt film 34b are in a relationship of being parallel to each other. The surface (upper surface) of the Pt film 34a and the (001)-surface as the crystal face of the monocrystalline PZT film 15 are joined together by intermolecular force. The surface (upper surface) of the Pt film 34b and the (0001)-surface as the crystal face of the monocrystalline AlN film 25 are joined together by intermolecular force. For these joints, the use of an adhesive agent is unnecessary. For excellently joining these surfaces by intermolecular force, the surface roughness of the Pt film 34a and the Pt film 34b is desired to be less than or equal to 10 nm. For this purpose, a process for smoothing the surfaces of the Pt film 34a and the Pt film 34b may be executed.

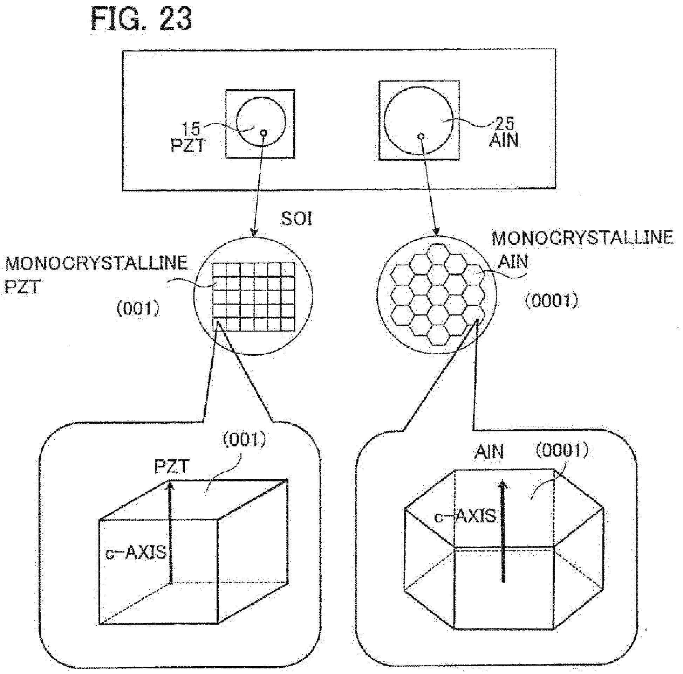

Further, a crystal c-axis direction of the monocrystalline PZT film 15 and a crystal c-axis direction of the monocrystalline AlN film 25 are in the parallel relationship. This feature will be described later by using Fig. 23. (1-2) Structure of Monocrystalline PZT Film

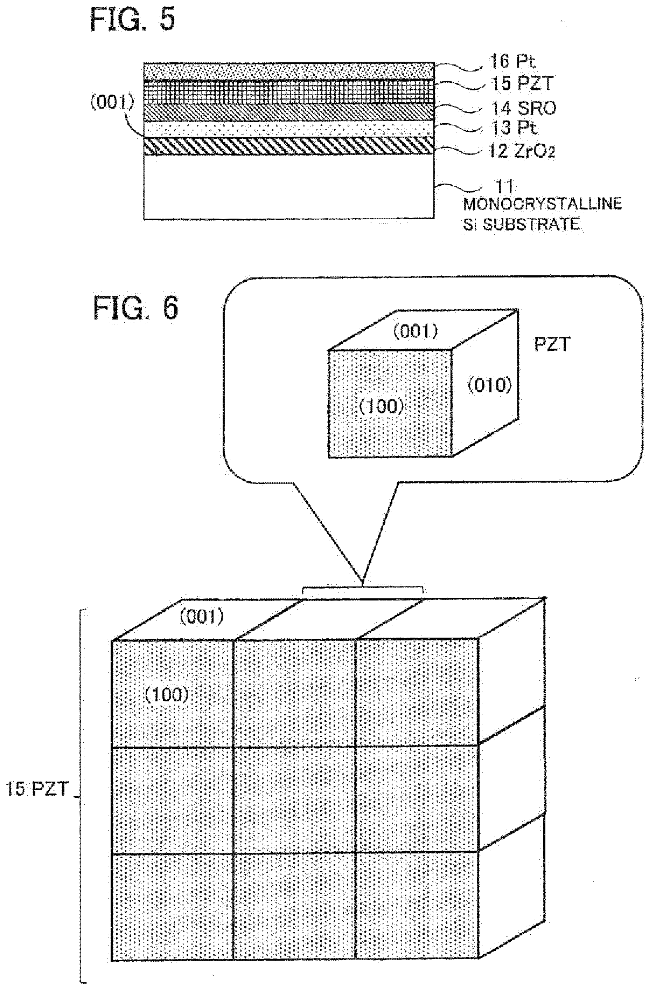

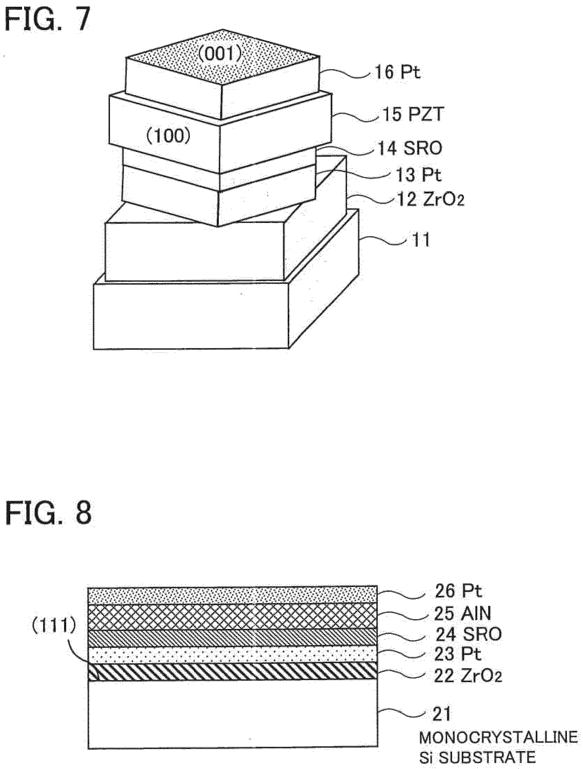

Fig. 5 is a cross-sectional view schematically showing the structure of the epitaxial growth film including the monocrystalline PZT film 15. Fig. 6 is a diagram showing the crystal structure of the monocrystalline PZT film 15 in Fig. 5. Fig. 7 is a diagram schematically showing the crystal structure of the epitaxial growth film in Fig. 5. Incidentally, in Fig. 7, the dimension in a vertical direction is reduced greatly compared to the dimension in a horizontal direction.

The epitaxial growth film in Fig. 5 is formed on a growth substrate 11 that is a monocrystalline Si substrate. The epitaxial growth film in Fig. 5 has a structure in which a monocrystalline zirconium dioxide (ZrO₂) film 12, a monocrystalline Pt film 13, a monocrystalline SRO film 14, a monocrystalline PZT film 15 and a monocrystalline Pt film 16 are stacked in this order. The growth substrate 11 is an example of a substrate whose upper surface is a (100)-surface. The ZrO₂ film 12 is an example of an orientation film having a cubic crystal structure and whose upper surface is a (100) -surface. The Pt film 13 is an example of a conductive film having a cubic crystal structure and whose upper surface is a (100) -surface. The SRO film 14 is a SrRuO₃ film (strontium ruthenate film) and is an example of an orientation film. The monocrystalline PZT film 15 is an example of a monocrystalline piezoelectric film for outputting oscillation. In cases where the monocrystalline PZT film 15 includes complex oxide having perovskite structure, the monocrystalline PZT film 15 can be grown epitaxially in the (001)-orientation in the cubic crystal representation on the growth substrate 11. On the monocrystalline PZT film 15, the Pt film 16 having a cubic crystal structure and being (100)-oriented is further grown epitaxially.

"The ZrO₂ film 12 is (100)-oriented" means that the (100)-surface of the ZrO₂ film 12 having a cubic crystal structure is formed along the (100)-surface of the growth substrate 11, namely, is parallel to the (100)-surface of the growth substrate 11. Further, "is parallel to" also means a state in which an angle formed by the upper surface of the growth substrate 11 and the (100)-surface of the ZrO₂ film 12 is less than or equal to 20°. Furthermore, the meaning of "orientation" is the same also for relationship between other films.

Table 1 shows the lattice constant of monocrystalline Si of the growth substrate 11, the lattice constant of ZrO₂ of the ZrO₂ film 12, the lattice constant of Pt of the Pt film 13, the lattice constant of SRO of the SRO film 14, and the lattice constant of monocrystalline PZT of the monocrystalline PZT film 15.

| TABLE 1 | |
|---|---|
| MATERIAL | LATTICE CONSTANT [nm] |
| MONOCRYSTALLINE PZT | 0.411 |
| SRO | 0.390 - 0.393 |
| Pt | 0.392 (0.544) |
| ZrO₂ | 0.511 |
| Si | 0.543 |

The lattice constant of Si is 0.543 nm, the lattice constant of ZrO₂ is 0.511 nm, and inconsistency of the lattice constant of ZrO₂ with the lattice constant of Si is as small as 6.1%, and thus the consistency of the lattice constant of ZrO₂ with the lattice constant of Si is high. Therefore, as shown in the schematic diagram of Fig. 7, the ZrO₂ film 12 as an orientation film can be grown epitaxially on a principal surface formed by the (100)-surface of the growth substrate 11. Accordingly, the ZrO₂ film 12 can be (100)-oriented in a cubic crystal structure on the (100)-surface of the growth substrate 11, and crystallinity of the ZrO₂ film 12 can be improved.

In cases where the ZrO₂ film 12 is a zirconium dioxide film having a cubic crystal structure and (100)-oriented, the ZrO₂ film 12 is oriented so that the ZrO₂ film 12's <100> direction along the upper surface of the growth substrate 11 as the principal surface is parallel to the <100> direction along the upper surface of the growth substrate 11.

Incidentally, "the ZrO₂ film 12's <100> direction along the upper surface of the growth substrate 11 is parallel to the <100> direction along the upper surface of the growth substrate 11" means not only that the ZrO₂ film 12's <100> direction is perfectly parallel to the <100> direction along the upper surface of the substrate 11 but also a state in which an angle formed by the zirconium dioxide film 12's <100> direction and the <100> direction along the upper surface of the growth substrate 11 is less than or equal to 20°. The same goes not only for the ZrO₂ film 12 but also for in-plane orientation of a film in a different layer.

Meanwhile, although the lattice constant of ZrO₂ is 0.511 nm and the lattice constant of Pt is 0.392 nm as shown in Table 1, if Pt is rotated in a plane by 45°, the length of a diagonal line is 0.554 nm and the inconsistency of the length of the diagonal line with the lattice constant of ZrO₂ is as small as 8.1%. Thus, the Pt film 13 can be grown epitaxially on the (100)-surface of the ZrO₂ film 12.

Further, as shown in Table 1, the lattice constant of Pt is 0.392 nm, the lattice constant of SRO is 0.390 - 0.393 nm, and the inconsistency of the lattice constant of SRO with the lattice constant of Pt is as small as 0.5% or less. Thus, the consistency of the lattice constant of SRO with the lattice constant of Pt is high, and the SRO film 14 can be grown epitaxially on the (100)-surface of the Pt film 13 as shown in Fig. 7. Accordingly, the SRO film 14 can be (100)-oriented in the pseudo-cubic crystal representation on the (100)-surface of the Pt film 13, and the crystallinity of the SRO film 14 can be improved.

In cases where the monocrystalline PZT film 15 has a cubic crystal structure and includes a (100)-oriented PZT film, the piezoelectric zirconate titanate (lead zirconate titanate) film is oriented so that its <100> direction along the upper surface of the growth substrate 11 is parallel to the <100> direction along the upper surface of the growth substrate 11.

On the (001)-oriented monocrystalline PZT film 15, the Pt film 16 is grown epitaxially in the (100)-orientation and thereby formed as an electrode. The electrode film on the monocrystalline PZT film 15 is the uppermost layer, and thus may also be formed by a different manufacturing method.

### (1-3) Structure of Monocrystalline AlN Film

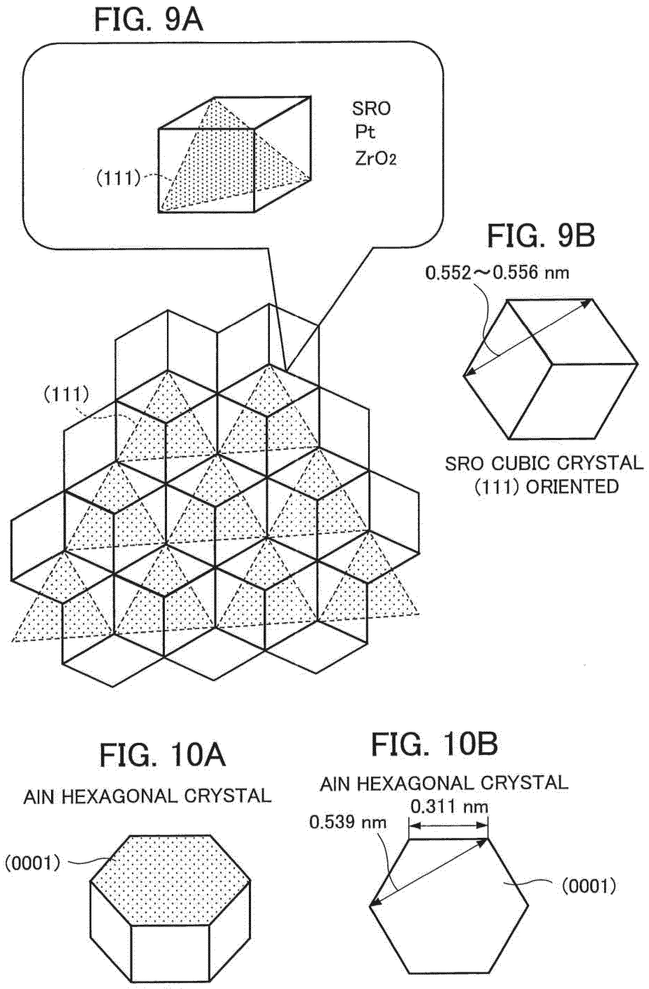

Fig. 8 is a cross-sectional view schematically showing the structure of the epitaxial growth film including the monocrystalline AlN film 25 as a monocrystalline piezoelectric film. Fig. 9A is a diagram schematically showing a (111)-surface of the crystal of each of the monocrystalline SRO film, the monocrystalline Pt film and the monocrystalline ZrO₂ film, and Fig. 9B is a diagram showing the lattice constant of the crystal of monocrystalline SRO. Fig. 10A is a diagram schematically showing the crystal structure of the monocrystalline AlN film 25, and Fig. 10B is a diagram showing the lattice constant of the crystal of the monocrystalline AlN film 25.

The epitaxial growth film in Fig. 8 is formed on a growth substrate 21 that is a monocrystalline Si substrate, for example. The epitaxial growth film has a structure in which a ZrO₂ film 22, a Pt film 23, an SRO film 24, a monocrystalline AlN film 25 and a Pt film 26 are stacked in this order. The growth substrate 21 is an example of a substrate whose upper surface is a (111)-surface. The ZrO₂ film 22 is an example of an orientation film having a cubic crystal structure and whose upper surface is a (111)-surface. The Pt film 23 is an example of a conductive film having a cubic crystal structure and whose upper surface is a (111)-surface. The SRO film 24 is a SrRuO₃ film. The monocrystalline AlN film 25 is an example of a monocrystalline piezoelectric film for detecting oscillation (i.e., for input). The Pt film 26 is an example of an upper electrode. In Fig. 9A, the shape of the (111)-surface of the SRO cubic crystal as bird's-eye viewed from above is shown. In Fig. 10A, the shape of the (0001)-surface as a crystal face of the AlN hexagonal crystal as bird's-eye viewed from above is shown.

In cases where the monocrystalline AlN film 25 is formed of a hexagonal crystal of aluminum nitride, the monocrystalline AlN film 25 can be grown epitaxially in the (0001)-orientation in the hexagonal crystal representation on the growth substrate 21. On the monocrystalline AlN film 25, the Pt film 26 having a cubic crystal structure and (100)-oriented can be further grown epitaxially.

"The ZrO₂ film 22 is (111)-oriented" means that the (111)-surface of the ZrO₂ film 22 having a cubic crystal structure is along the (111)-surface of the growth substrate 21, namely, is parallel to the (111)-surface of the growth substrate 21. Further, "parallel" also means a state in which an angle formed by the (111)-surface of the ZrO₂ film 22 and the principal surface of the growth substrate 21 is less than or equal to 20°. The same goes for orientation between other layers.

Table 2 shows the lattice constant of Si, the lattice constant of ZrO₂, the lattice constant of Pt, the lattice constant of SRO, and the lattice constant of monocrystalline AlN.

| TABLE 2 | |
|---|---|
| MATERIAL | LATTICE CONSTANT [nm] |
| MONOCRYSTALLINE AlN | 0.311 |
| SRO | 0.390 - 0.393 |
| Pt | 0.392 (0.544) |
| ZrO₂ | 0.511 |
| Si | 0.543 |

The lattice constant of Si is 0.543 nm, the lattice constant of ZrO₂ is 0.511 nm, and the inconsistency of the lattice constant of ZrO₂ with the lattice constant of Si is as small as 6.1%, and thus the consistency of the lattice constant of ZrO₂ with the lattice constant of Si is high. Thus, the ZrO₂ film 22 can be grown epitaxially on a principal surface formed by the (111)-surface of the growth substrate 21. Accordingly, the ZrO₂ film 22 can be (111)-oriented in a cubic crystal structure on the (111)-surface of the growth substrate 21, and the crystallinity of the ZrO₂ film 22 can be improved. The (111)-surface of the cubic crystal is shown in Fig. 9A.

In cases where the ZrO₂ film 22 as an orientation film is a zirconium dioxide film having a cubic crystal structure and (111)-oriented, the ZrO₂ film 22 is oriented so that the ZrO₂ film 22's <111> direction along the upper surface of the growth substrate 21 as the principal surface is parallel to the <111> direction along the upper surface of the growth substrate 21.

Incidentally, "the ZrO₂ film 22's <111> direction along the upper surface of the growth substrate 21 is parallel to the <111> direction along the upper surface of the growth substrate 21" means not only that the ZrO₂ film 22's <111> direction is perfectly parallel to the <111> direction along the upper surface of the growth substrate 21 but also a state in which an angle formed by the ZrO₂ film 22's <111> direction and the <111> direction along the upper surface of the growth substrate 21 is less than or equal to 20°. The same goes for orientation between films in different layers.

Meanwhile, although the lattice constant of ZrO₂ is 0.511 nm and the lattice constant of Pt is 0.392 nm, if Pt is rotated in a plane by 45°, the length of a diagonal line is 0.554 nm and the inconsistency of the length of the diagonal line with the lattice constant of ZrO₂ is as small as 8.1%, and thus the Pt film 23 can be grown epitaxially on the (111)-surface of the ZrO₂ film 22.

Further, the lattice constant of Pt is 0.392 nm, the lattice constant of SRO is 0.390 - 0.393 nm, and the consistency of the lattice constant of SRO with the lattice constant of Pt is high. Thus, the SRO film 24 can be grown epitaxially on the (111)-surface of the Pt film 23 as shown in Figs. 9A and 9B. Accordingly, the SRO film 24 can be (111)-oriented in the pseudo-cubic crystal representation on the (111)-surface of the Pt film 23, and the crystallinity of the SRO film 24 can be improved. The length of the diagonal line of the (111)-surface of the SRO film is 0.552 - 0.556 nm and the inconsistency with the width 0.539 nm of the AlN hexagonal crystal is as small as 2.8% as shown in Fig. 10B, and thus the monocrystalline AlN film 25 can be grown epitaxially in the (0001)-orientation on the (111)-surface of the SRO film 24.

In cases where the monocrystalline AlN film 25 has a hexagonal crystal structure and includes a (0001)-oriented aluminum nitride film, the monocrystalline AlN film 25 is oriented so that its <111> direction along the upper surface of the growth substrate 21 is parallel to the <111> direction of the upper surface of the growth substrate 21. The (0001)-surface of the hexagonal crystal is shown in Figs. 10A and 10B. On the (0001)-oriented monocrystalline AlN film 25, the Pt film 26 is further grown epitaxially in the (111)-orientation and thereby formed as an electrode. The electrode film on the monocrystalline AlN film 25 is the uppermost layer, and thus may also be formed by a different manufacturing method.

### (1-4) Manufacturing Method

A method for manufacturing the piezoelectric film integrated device 100 by using the monocrystalline PZT film 15 deposited on the growth substrate 11 of monocrystalline Si whose upper surface is a (100)-surface and the monocrystalline AlN film 25 deposited on the growth substrate 21 of monocrystalline Si whose upper surface is a (111)-surface will be described below.

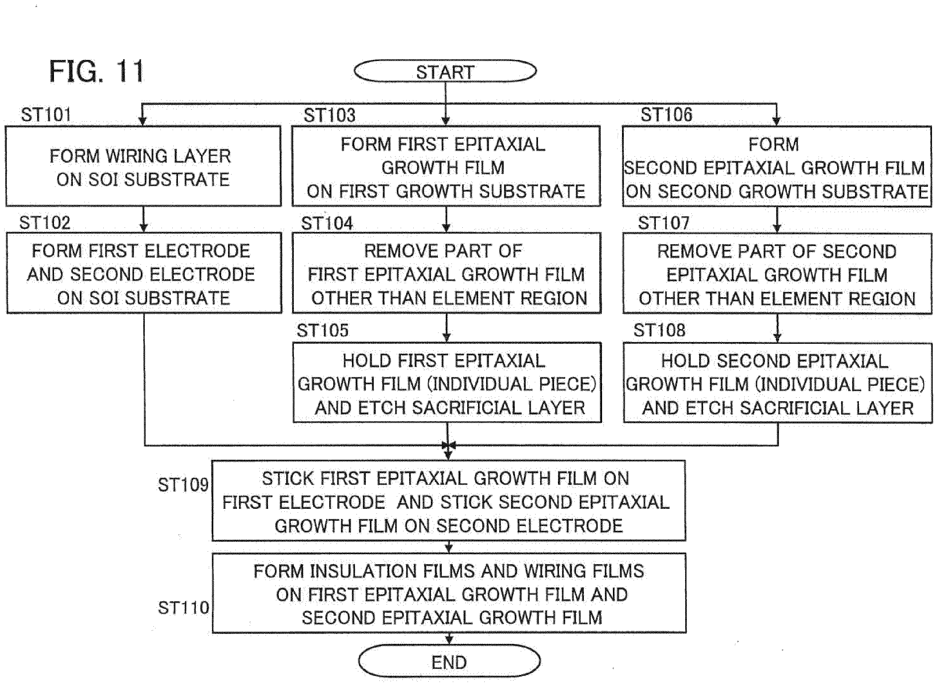

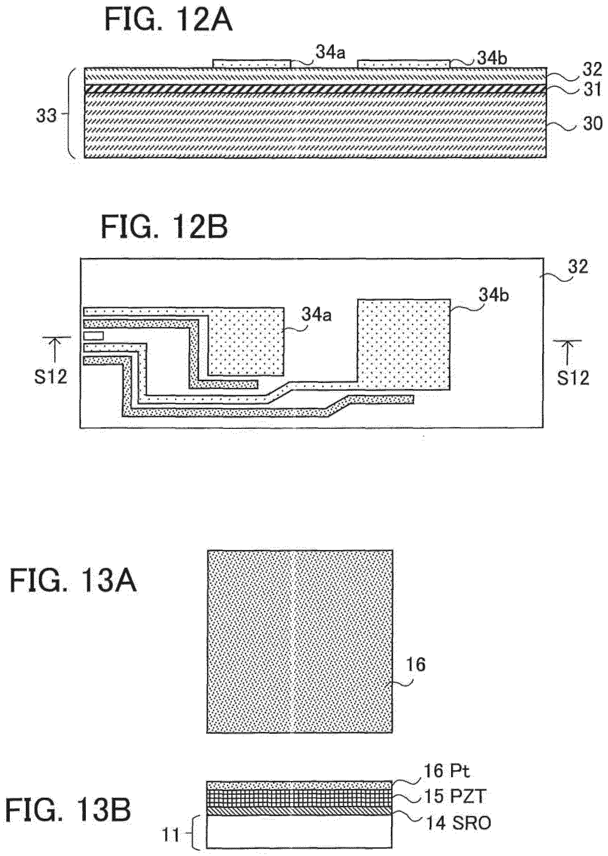

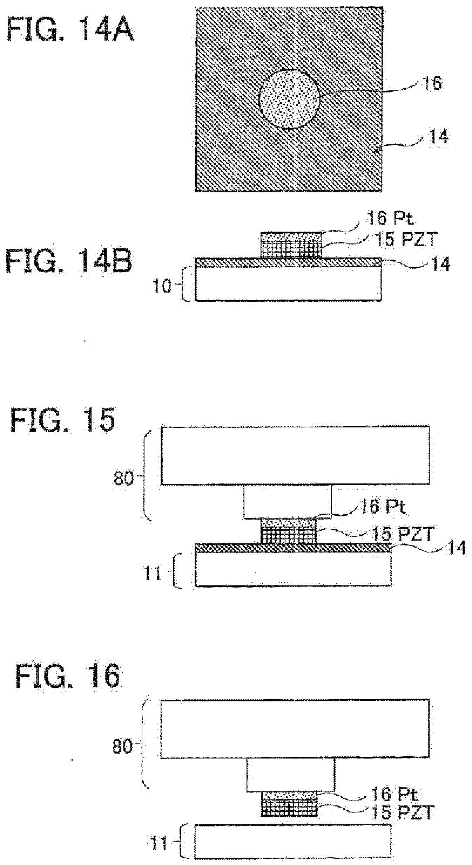

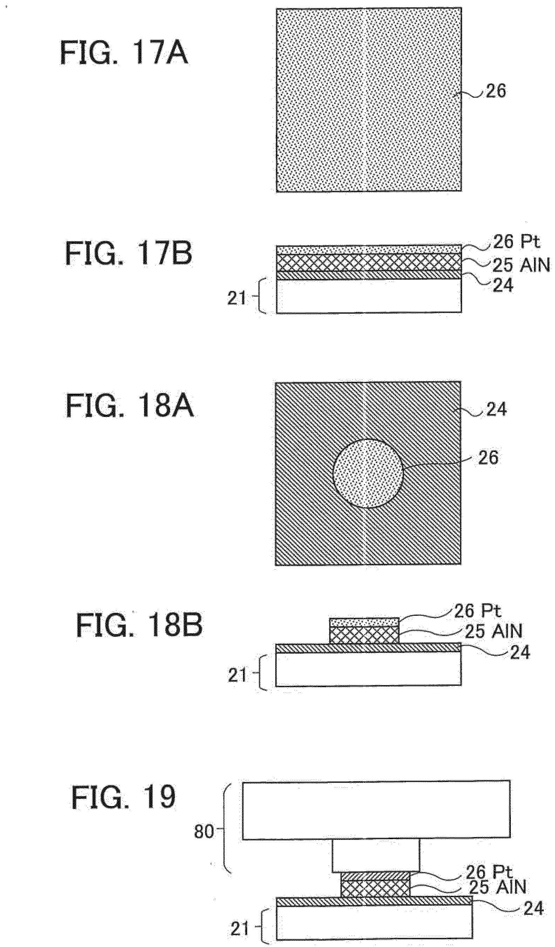

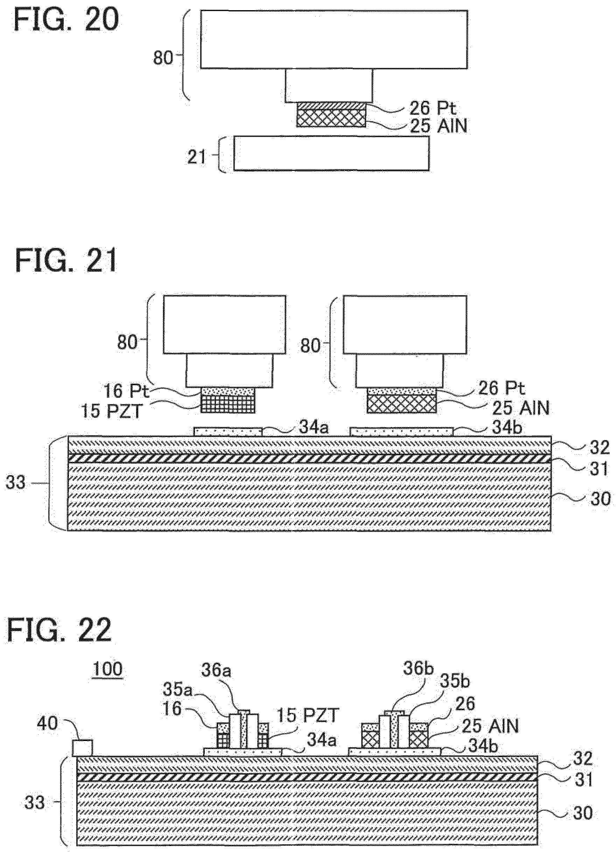

Fig. 11 is a flowchart showing a method of manufacturing the piezoelectric film integrated device 100. Figs. 12A and 12B show step ST102 in Fig. 11. Figs. 13A and 13B show step ST103 in Fig. 11, Figs. 14A and 14B show step ST104 in Fig. 11, and Fig. 15 and Fig. 16 show step ST105 in Fig. 11. Figs. 17A and 17B show step ST106 in Fig. 11, Figs. 18A and 18B show step ST107 in Fig. 11, and Fig. 19 and Fig. 20 show step ST108 in Fig. 11. Fig. 21 shows step ST109 in Fig. 11, and Fig. 22 shows step ST110 in Fig. 11.

First, a wiring layer is formed on the SOI substrate 33 being a device substrate (step ST101). Subsequently, as shown in Figs. 12A and 12B, the Pt film 34a as the first electrode and the Pt film 34b as the second electrode are formed on the principal surface of the SOI substrate 33.

Further, the SRO film 14, the monocrystalline PZT film 15 and the Pt film 16 are grown epitaxially on the growth substrate 11 as a first growth substrate as shown in Figs. 13A and 13B (step ST103), and the monocrystalline PZT film 15 is formed into a circular shape by means of etching as shown in Figs. 14A and 14B (step ST104). Thereafter, an individual piece formed with the monocrystalline PZT film 15 and the Pt film 16 is held by a stamp 80 as a holding member as shown in Fig. 15, and the individual piece is peeled off by etching the SRO film 14 as a sacrificial layer as shown in Fig. 16 and is moved onto the SOI substrate 33 being the device substrate (step ST105).

Furthermore, the SRO film 24, the monocrystalline AlN film 25 and the Pt film 26 are grown epitaxially on the growth substrate 21 as a second growth substrate as shown in Figs. 17A and 17B (step ST106), and the monocrystalline AlN film 25 is formed into a circular shape by means of etching as shown in Figs. 18A and 18B (step ST107). Thereafter, an individual piece formed with the monocrystalline AlN film 25 and the Pt film 26 is held by the stamp 80 as the holding member as shown in Fig. 19, and the individual piece is peeled off by etching the SRO film 24 as a sacrificial layer as shown in Fig. 20 and is moved onto the SOI substrate 33 (step ST108).

Subsequently, as shown in Fig. 21, the individual piece (first epitaxial growth film) formed with the monocrystalline PZT film 15 and the Pt film 16 is stuck (or bonded) on the Pt film 34a as the first electrode, and the individual piece (second epitaxial growth film) formed with the monocrystalline AlN film 25 and the Pt film 26 is stuc (or bonded) on the Pt film 34b as the second electrode (step ST109). Subsequently, the insulation film 35a and the wiring film 36a are formed on the monocrystalline PZT film 15 and the Pt film 16, and the insulation film 35b and the wiring film 36b are formed on the monocrystalline AlN film 25 and the Pt film 26.

Fig. 23 is a diagram showing crystal c-axes of the monocrystalline PZT film 15 as the first monocrystalline piezoelectric film and the monocrystalline AlN film 25 as the second monocrystalline piezoelectric film. As shown in Fig. 23, at the time of the sticking, the hexagonal crystal of AlN and the cubic crystal of PZT are arranged in a phase relationship so that their c-axes are parallel to each other as illustrated, by which efficiency of the piezoelectric oscillation driving of the monocrystalline PZT film 15 and the piezoelectric oscillation reception of the monocrystalline AlN film 25 is maximized.

After the sticking, the insulation films 35a and 35b are formed on the SOI substrate 33, and the wiring films 36a and 36b are formed on the electrodes and connected to a prescribed wiring pattern.

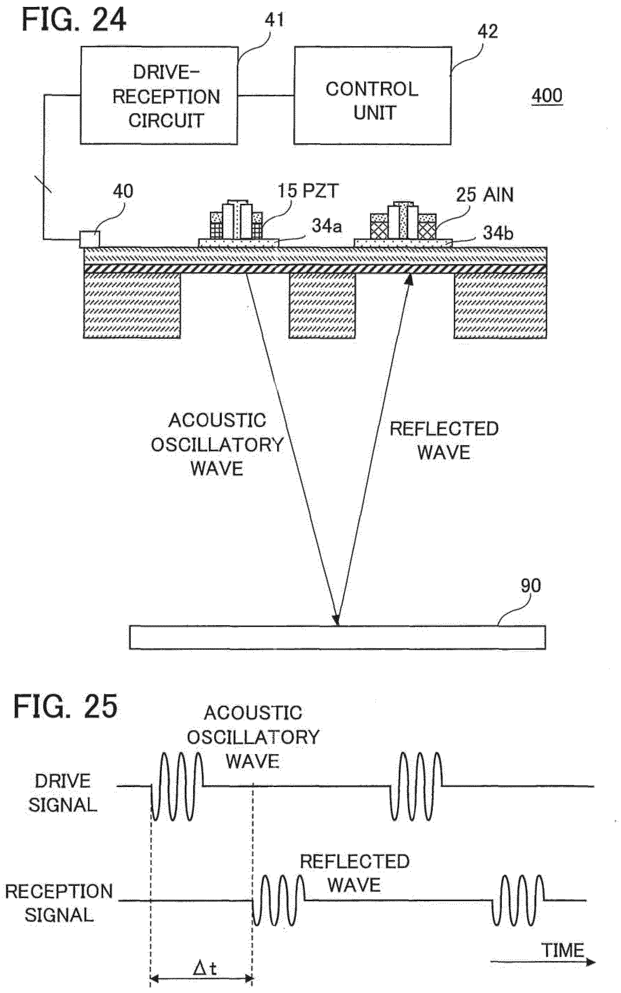

As shown in Fig. 24, the SOI substrate 33 is etched up to the SiO₂ part 31, thereby thinning down a back side of each piezoelectric element and forming the vibrating plate. The thickness of the vibrating plate can be set at a desired thickness by controlling the thickness of each layer of the SOI substrate 33.

### (1-5) Acoustic Oscillation Sensor

Fig. 24 schematically shows the configuration of the acoustic oscillation sensor 400 employing a semiconductor integrated device according to the first embodiment. Fig. 25 shows a principle of operation of the acoustic oscillation sensor. Upper and lower electrodes of the monocrystalline PZT film 15 are connected to a drive-reception circuit 41 and an AC bias at a frequency in the audible range or a frequency higher than the audible range is applied to the electrodes of the monocrystalline PZT film 15, by which the monocrystalline PZT film 15 oscillates in its thickness direction and the SiO₂ part 31 also oscillates in a similar manner. Due to the oscillation, the acoustic oscillatory wave is radiated and reflected waves bounced off a detection target object 90 oscillate the vibrating plate of the SOI substrate 33 having the monocrystalline AlN film 25 stuck thereon. Electric charge excited in the monocrystalline AlN film 25 due to the oscillation is amplified by the drive-reception circuit 41, and a control circuit 42 computes a distance to the detection target object 90 based on a time difference Δt regarding the reception of the reflected waves. The control circuit 42 and the drive-reception circuit 41 are formed by an electric circuit or an information processing device.

### (1-6) Modification

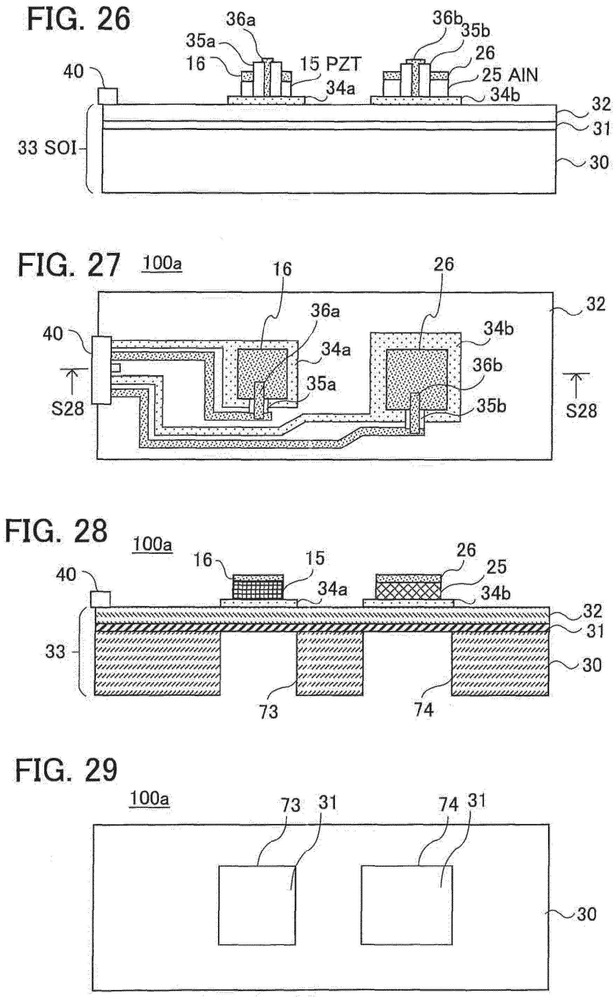

Fig. 26 is a side view schematically showing the structure of a piezoelectric film integrated device 100a according to a modification of the first embodiment. Fig. 27 is a top view schematically showing the structure of the piezoelectric film integrated device 100a. Fig. 28 is a cross-sectional view of the piezoelectric film integrated device 100a in Fig. 27 taken along the line S28-S28. Fig. 29 is a bottom view schematically showing the structure of the piezoelectric film integrated device 100a. When the SOI substrate 33 is etched up to the SiO₂ part 31, each cavity 73, 74 may also be formed into a shape other than the circular shape, such as a quadrangular shape. The shape of each cavity 73, 74 is desired to be a shape corresponding to a two-dimensional shape of the piezoelectric element.

### (1-7) Effect

As described above, the monocrystalline PZT film 15 and the monocrystalline AlN film 25, which are unlikely to grow epitaxially on the same SOI substrate 33 because of the difference in the lattice constant and the crystal structure, are respectively grown in monocrystalline epitaxial growth on separate growth substrates, peeled off from the growth substrates, and stuck (or bonded) on a common SOI substrate 33, by which a high-performance piezoelectric film integrated device 100 can be manufactured.

Further, since the monocrystalline PZT film 15 has a higher piezoelectric constant compared to a polycrystalline PZT film, amplitude of the oscillation can be increased with ease.

Furthermore, since the monocrystalline AlN film 25 has lower specific inductive capacity compared to a polycrystalline AlN film, the oscillation reception sensitivity can be increased.

Moreover, conventionally, in order to form piezoelectric films of different types, a process like temporarily covering one piezoelectric film with a protective layer, forming the other piezoelectric film, and thereafter removing the protective layer used to be a complicated process, and application of heat in processing in each step used to leave residual stress distortion in the piezoelectric films and cause deterioration in the efficiency of the sensor. In the manufacturing method in the first embodiment, the sticking of the epitaxial growth films as the monocrystalline piezoelectric films is employed, and thus the piezoelectric film integrated device and the acoustic oscillation sensor can be formed in a state with no residual stress distortion.

### (2) Second Embodiment

### (2-1) Structure

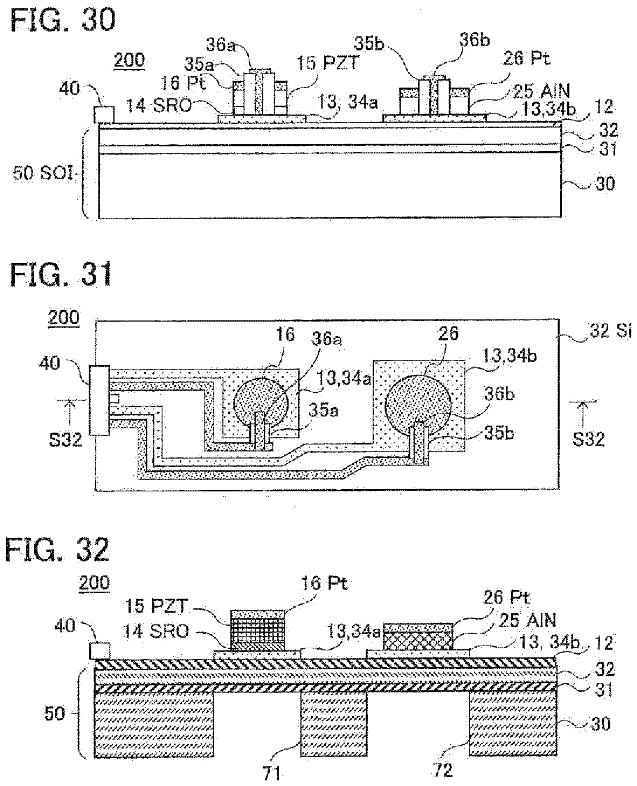

Fig. 30 is a side view schematically showing the structure of a piezoelectric film integrated device 200. Fig. 31 is a top view schematically showing the structure of the piezoelectric film integrated device 200. Fig. 32 is a cross-sectional view of the piezoelectric film integrated device 200 in Fig. 31 taken along the line S32-S32.

While both of the monocrystalline PZT film 15 and the monocrystalline AlN film 25 are respectively grown on the growth substrates 11 and 21 and stuck (or bonded) on the Pt films on the SOI substrate 33 in the first embodiment, the monocrystalline PZT film 15 is epitaxially grown on an SOI substrate 50 in a second embodiment. The upper surface of the SOI substrate 50 is formed by a (100)-surface. Therefore, a single crystal of the monocrystalline PZT film 15 can be grown epitaxially by a process similar to the process in the first embodiment.

### (2-2) Manufacturing Method

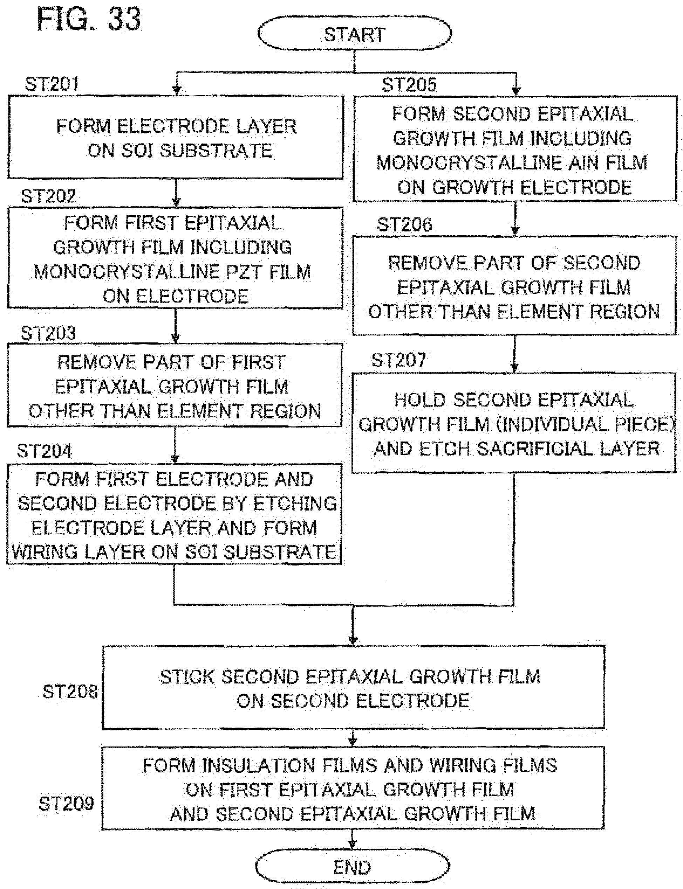

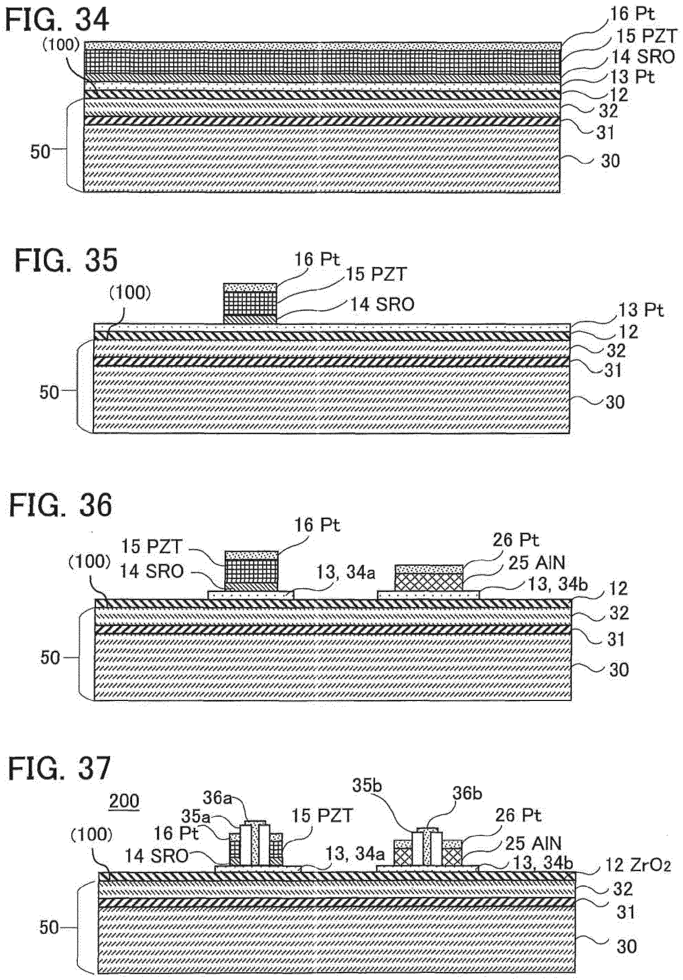

Fig. 33 is a flowchart showing a method of manufacturing the piezoelectric film integrated device 200. Fig. 34 shows steps ST201 and ST202 in Fig. 33, and Fig. 35 shows step ST203 in Fig. 33. Fig. 36 shows step ST208 in Fig. 33, and Fig. 37 shows step ST209 in Fig. 33.

First, as shown in Fig. 34, the ZrO₂ film 12 and the Pt film 13 as an electrode layer are formed on the principal surface of the SOI substrate 50 being the device substrate (step ST201). Subsequently, as shown in Fig. 34, an epitaxial growth film made up of the SRO film 14, the monocrystalline PZT film 15 and the Pt film 16 is formed by epitaxially growing the SRO film 14, the monocrystalline PZT film 15 and the Pt film 16 on the Pt film 13 (step ST202). Subsequently, as shown in Fig. 35, the epitaxial growth film including the monocrystalline PZT film 15 is formed into a desired shape (e.g., circular shape) by means of etching (step ST203). Subsequently, the Pt film 34a as the first electrode and the Pt film 34b as the second electrode are formed by etching the Pt film 13 as the electrode layer.

Subsequently, the individual piece formed with the monocrystalline AlN film 25 and the Pt film 26 is held by the stamp 80 as the holding member, peeled off by etching the SRO film 24 as the sacrificial layer, and moved onto and stuck (or bonded) on the SOI substrate 50 being the device substrate as shown in Fig. 36 (steps ST205 to ST208). In this case, the monocrystalline AlN film 25 described in the first embodiment, formed separately, is stuck (or bonded) on the electrode. At the time of the sticking, the crystal orientation of the monocrystalline PZT film 15 is checked by an inspection or the like, and the crystal orientation of the monocrystalline PZT film 15 and the crystal orientation of the monocrystalline AlN film 25 are aligned with each other as shown in Fig. 23. Since the orientation of the monocrystalline PZT film 15 is fixed on the SOI substrate 50, the angle of the sticking of the monocrystalline AlN film 25 is adjusted. It is also possible to check the crystal orientation at the time of the etching process shown in Fig. 35 and thereafter form the piezoelectric film to be in the same orientation as in the first embodiment by using a mask. As shown in Fig. 37, the insulation film 35a and the wiring film (lead wiring) 36a are formed on the monocrystalline PZT film 15 and the Pt film 16, and the insulation film 35b and the wiring film (lead wiring) 36b are formed on the monocrystalline AlN film 25 and the Pt film 26.

Thereafter, the manufacture of the piezoelectric film integrated device 200 shown in Fig. 30 to Fig. 32 is completed by etching the SOI substrate 50 similarly to the first embodiment.

### (2-3) Effect

In the second embodiment, the epitaxial growth film including the monocrystalline AlN film 25 is stuck on the Pt film 34b on the SOI substrate 50 having the epitaxially grown monocrystalline PZT film 15 thereon, by which a monocrystalline and high-performance piezoelectric film integrated device can be obtained similarly to the first embodiment.

In the second embodiment, alignment accuracy of the monocrystalline PZT film 15 increases compared to the first embodiment. Therefore, in the second embodiment, the acoustic oscillatory wave output performance increases compared to the first and third embodiments.

Except for the above-described features, the second embodiment is the same as the first embodiment.

### (3) Third Embodiment

### (3-1) Structure

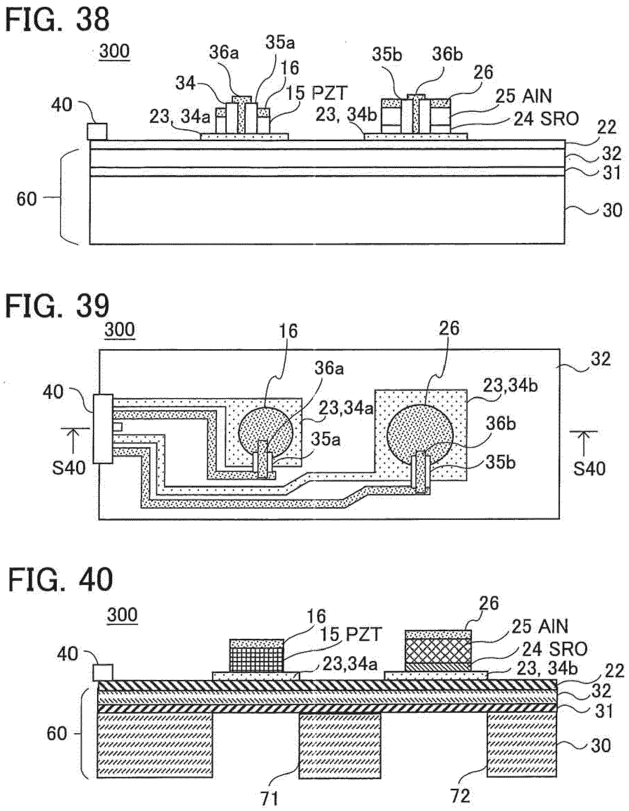

Fig. 38 is a side view schematically showing the structure of a piezoelectric film integrated device 300. Fig. 39 is a top view schematically showing the structure of the piezoelectric film integrated device 300. Fig. 40 is a cross-sectional view of the piezoelectric film integrated device in Fig. 39 taken along the line S40-S40.

While both of the monocrystalline PZT film 15 and the monocrystalline AlN film 25 are respectively grown on the growth substrates 11 and 21 and stuck (or bonded) on the Pt films on the SOI substrate 33 in the first embodiment, the monocrystalline AlN film 25 is epitaxially grown on an SOI substrate 60 in a third embodiment. The upper surface of the SOI substrate 60 is formed by a (111)-surface. Therefore, a single crystal of the monocrystalline AlN film 25 can be grown epitaxially by a process similar to the process in the first embodiment.

### (3-2) Manufacturing Method

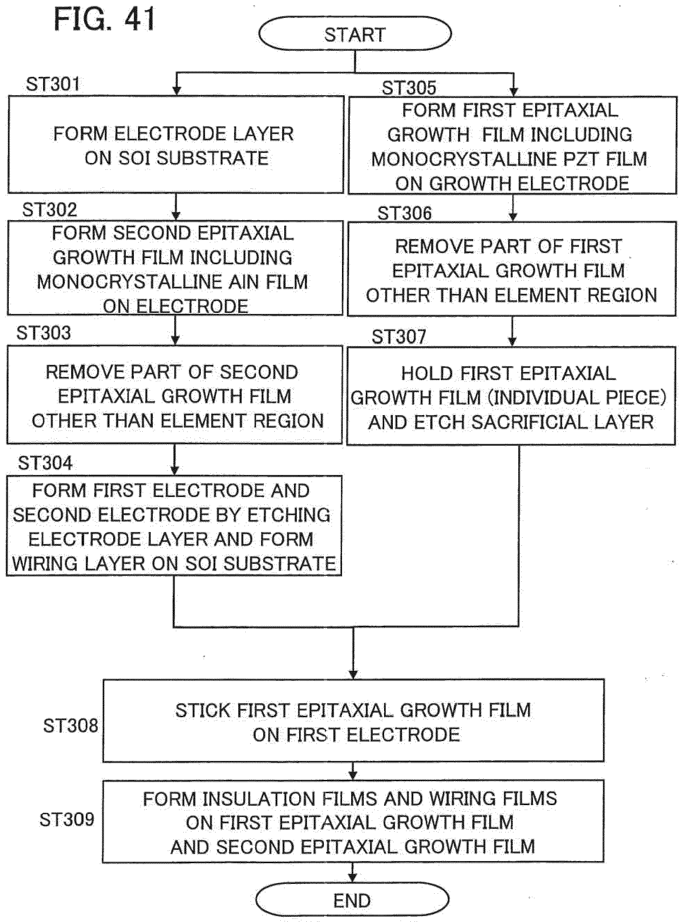

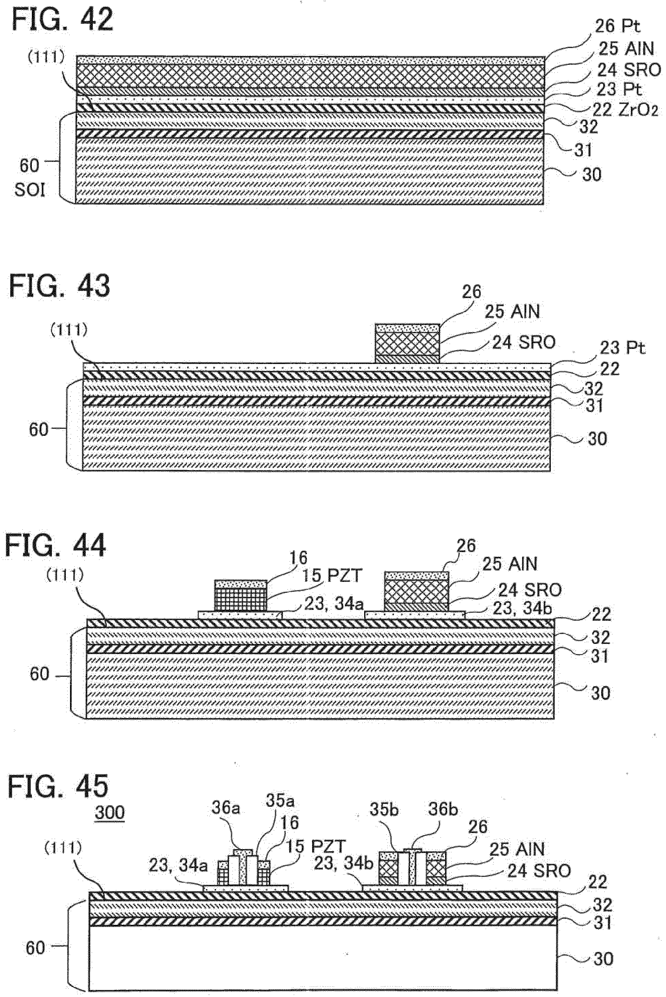

Fig. 41 is a flowchart showing a method of manufacturing the piezoelectric film integrated device 300. Fig. 42 shows steps ST301 and ST302 in Fig. 41, Fig. 43 shows step ST303 in Fig. 41, Fig. 44 shows step ST308 in Fig. 41, and Fig. 45 shows step ST309 in Fig. 41.

First, as shown in Fig. 42, the ZrO₂ film 22 and the Pt film 23 as an electrode layer are formed on the principal surface of the SOI substrate 60 being the device substrate (step ST301). Subsequently, as shown in Fig. 42, an epitaxial growth film made up of the SRO film 24, the monocrystalline AlN film 25 and the Pt film 26 is formed by epitaxially growing the SRO film 24, the monocrystalline AlN film 25 and the Pt film 26 on the Pt film 23 (step ST302). Subsequently, as shown in Fig. 43, the epitaxial growth film including the monocrystalline AlN film 25 is formed into a desired shape (e.g., circular shape) by means of etching (step ST303). Subsequently, the Pt film 34a as the first electrode and the Pt film 34b as the second electrode are formed by etching the Pt film 23 as the electrode layer.

Subsequently, the individual piece formed with the monocrystalline PZT film 15 and the Pt film 16 is held by the stamp 80 as the holding member, peeled off by etching the SRO film 14 as the sacrificial layer, and moved onto and stuck (or bonded) on the SOI substrate 60 being the device substrate as shown in Fig. 44 (steps ST305 to ST308). In this case, the monocrystalline PZT film 15 described in the first embodiment, formed separately, is stuck (or bonded) on the electrode. At the time of the sticking, the crystal orientation of the monocrystalline AlN film 25 is checked by an inspection or the like, and the crystal orientation of the monocrystalline PZT film 15 and the crystal orientation of the monocrystalline AlN film 25 are aligned with each other as shown in Fig. 23. Since the orientation of the monocrystalline AlN film 25 is fixed on the SOI substrate 60, the angle of the sticking of the monocrystalline PZT film 15 is adjusted. It is also possible to check the crystal orientation at the time of the etching process shown in Fig. 43 and thereafter form the piezoelectric film to be in the same orientation as in the first embodiment by using a mask.

The insulation films 35a and 35b are formed, and electrodes of the piezoelectric films are connected to an electrode pattern by the wiring films (lead wiring) 36a and 36b. Thereafter, the manufacture of the piezoelectric film integrated device 300 shown in Fig. 38 to Fig. 40 is completed by etching the SOI substrate 60 similarly to the first embodiment.

### (3-3) Effect

In the third embodiment, the monocrystalline PZT film 15 is stuck on the electrode on the SOI substrate 60 having the epitaxially grown monocrystalline AlN film 25 thereon, by which a monocrystalline and high-performance piezoelectric film integrated device 300 can be obtained similarly to the first embodiment.

In the third embodiment, the alignment accuracy of the monocrystalline AlN film 25 increases compared to the first embodiment. Therefore, in the third embodiment, the acoustic oscillatory wave detection sensitivity and the S/N ratio increase compared to the first and second embodiments.

Except for the above-described features, the third embodiment is the same as the first or second embodiment.

### (4) First Modification

A piezoelectric film integrated device 500 according to a first modification differs from the piezoelectric film integrated device 100 according to the first embodiment in which the epitaxial growth film stuck (or bonded) on the Pt film 34a is formed with the monocrystalline PZT film 15 and the Pt film 16 and the epitaxial growth film stuck (or bonded) on the Pt film 34b is formed with the monocrystalline AlN film 25 and the Pt film 26, in that the epitaxial growth film stuck (or bonded) on the Pt film (first electrode) 34a on the SOI substrate 33 is formed with a Pt film 116, the monocrystalline PZT film 15 and the Pt film 16 and the epitaxial growth film stuck (or bonded) on the Pt film (second electrode) 34b on the SOI substrate 33 is formed with a Pt film 126, the monocrystalline AlN film 25 and the Pt film 26. Except for these features, the piezoelectric film integrated device 500 according to the first modification is the same as the piezoelectric film integrated device 100 according to the first embodiment.

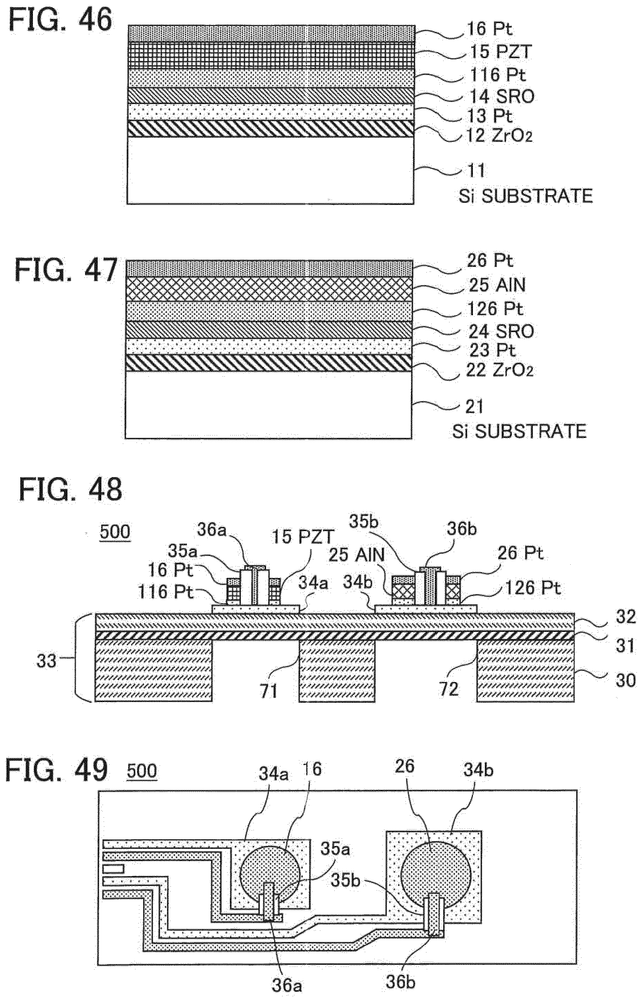

Fig. 46 is a cross-sectional view showing a state in which the Pt film 13, the SRO film 14, the Pt film 116, the monocrystalline PZT film 15 and the Pt film 16 have successively been grown epitaxially on the ZrO₂ film 12 on the Si substrate 11. Fig. 47 is a cross-sectional view showing a state in which the Pt film 23, the SRO film 24, the Pt film 126, the monocrystalline AlN film 25 and the Pt film 26 have successively been grown epitaxially on the ZrO₂ film 22 on the Si substrate 21.

Fig. 48 is a cross-sectional view schematically showing the structure of the piezoelectric film integrated device 500 according to the first modification. Fig. 49 is a top view schematically showing the structure of the piezoelectric film integrated device 500 in Fig. 48. In Fig. 48 and Fig. 49, each component identical or corresponding to a component shown in Fig. 1 to Fig. 4 (first embodiment) is assigned the same reference character as in Fig. 1 to Fig. 4. In the piezoelectric film integrated device 500 according to the first modification, the epitaxial growth film formed with the Pt film 116, the monocrystalline PZT film 15 and the Pt film 16 (shown in Fig. 46) is stuck (or bonded) on the Pt film 34a, and the epitaxial growth film formed with the Pt film 126, the monocrystalline AlN film 25 and the Pt film 26 (shown in Fig. 47) is stuck (or bonded) on the Pt film 34b. Except for these features, the piezoelectric film integrated device 500 according to the first modification is the same as the piezoelectric film integrated device 100 according to the first embodiment.

Incidentally, it is also possible to use the epitaxial growth film formed with the Pt film 116, the monocrystalline PZT film 15 and the Pt film 16 (shown in Fig. 46) instead of the epitaxial growth film formed with the monocrystalline PZT film 15 and the Pt film 16 in the piezoelectric film integrated device 200 according to the second embodiment (shown in Fig. 30 to Fig. 32). Further, it is also possible to use the epitaxial growth film formed with the Pt film 126, the monocrystalline AlN film 25 and the Pt film 26 (shown in Fig. 47) instead of the epitaxial growth film formed with the monocrystalline PZT film 25 and the Pt film 26 in the piezoelectric film integrated device 200 according to the second embodiment (shown in Fig. 30 to Fig. 32 and Fig. 42 to Fig. 45).

### (5) Second Modification

The piezoelectric film integrated devices 100, 200 and 300 and the acoustic oscillation sensors 400 according to the embodiments are usable not only for a distance sensor but also for other types of sensors such as a fingerprint sensor and a vein (pulse wave) sensor.

Further, with a piezoelectric film integrated device in which pairs of the monocrystalline PZT film 15 and the monocrystalline AlN film 25 are arranged in a matrix, a surface shape of the detection target object can be detected.

### (6) Description of Reference Characters

100, 100a, 200, 300, 500: piezoelectric film integrated device, 400: acoustic oscillation sensor, 11, 21: growth substrate (monocrystalline Si substrate), 15: monocrystalline PZT film (first monocrystalline piezoelectric film), 16: Pt film (third electrode), 14, 24: SRO film (orientation film), 25: monocrystalline AlN film (second monocrystalline piezoelectric film), 26: Pt film (fourth electrode), 31: SiO₂ part, 32: monocrystalline Si part, 33, 50, 60: SOI substrate (substrate), 34a: Pt film (first electrode), 34b: Pt film (second electrode), 71 - 74: cavity, 116: Pt film, 126: Pt film.

## Claims

1. A piezoelectric film integrated device (100, 100a, 200, 300, 500) comprising:
a substrate (33);
a first electrode (34a) provided on the substrate (33);
a second electrode (34b) provided on the substrate (33);
a first monocrystalline piezoelectric film (15) provided on the first electrode (34a);
a second monocrystalline piezoelectric film (25) provided on the second electrode (34b) and having a crystal structure different from a crystal structure of the first monocrystalline piezoelectric film (15);
a third electrode (16) provided on the first monocrystalline piezoelectric film (15); and
a fourth electrode (26) provided on the second monocrystalline piezoelectric film (25).

2. The piezoelectric film integrated device (100, 100a, 200, 300, 500) according to claim 1, wherein the substrate (33) includes vibrating plates (31) respectively provided in regions under the first monocrystalline piezoelectric film (15) and the second monocrystalline piezoelectric film (25).

3. The piezoelectric film integrated device (100, 100a, 200, 300, 500) according to claim 2, wherein
the substrate (33) is an SOI substrate that includes a Si substrate (30), a SiO₂ part (31) and a monocrystalline Si part (32), and
the vibrating plate (31) includes the SiO₂ part (31) and the monocrystalline Si part (32).

4. The piezoelectric film integrated device (100, 100a, 200, 300, 500) according to any one of claims 1 to 3, wherein
the first monocrystalline piezoelectric film (15) is a monocrystalline PZT film, a monocrystalline KNN film or a monocrystalline barium titanate film, and
the second monocrystalline piezoelectric film (25) is a monocrystalline AlN film, a monocrystalline lithium tantalate film or a monocrystalline lithium niobate film.

5. The piezoelectric film integrated device (100, 100a, 200, 300, 500) according to any one of claims 1 to 4, wherein the first monocrystalline piezoelectric film (15) is an epitaxial growth film having a (001)-surface as a crystal face parallel to a surface of the first electrode (34a).

6. The piezoelectric film integrated device (100, 100a, 200, 300, 500) according to any one of claims 1 to 4, wherein the first monocrystalline piezoelectric film (15) is an epitaxial growth film having a (001)-surface as a crystal face parallel to a surface of the first electrode (34a) and being stuck on the surface of the first electrode (34a).

7. The piezoelectric film integrated device (200, 300) according to any one of claims 1 to 4, further comprising an SRO film formed on the first electrode (34a),
wherein the first monocrystalline piezoelectric film (15) is an epitaxial growth film having a (001)-surface as a crystal face parallel to a surface of the SRO film and formed on the surface of the SRO film.

8. The piezoelectric film integrated device (100, 100a, 200, 300, 500) according to any one of claims 1 to 7, wherein the second monocrystalline piezoelectric film (25) is an epitaxial growth film having a (0001)-surface as a crystal face parallel to a surface of the second electrode (34b).

9. The piezoelectric film integrated device (100, 100a, 200, 300, 500) according to any one of claims 1 to 7, wherein the second monocrystalline piezoelectric film (25) is an epitaxial growth film having a (0001)-surface as a crystal face parallel to a surface of the second electrode (34b) and being stuck on the surface of the second electrode (34b).

10. The piezoelectric film integrated device (200, 300) according to any one of claims 1 to 6, further comprising an SRO film formed on the second electrode (34b),
wherein the second monocrystalline piezoelectric film (25) is an epitaxial growth film having a (0001)-surface as a crystal face parallel to a surface of the SRO film and formed on the surface of the SRO film.

11. The piezoelectric film integrated device (100, 100a, 200, 300, 500) according to any one of claims 1 to 10, wherein a crystal c-axis direction of the first monocrystalline piezoelectric film (15) and a crystal c-axis direction of the second monocrystalline piezoelectric film (25) are in a parallel relationship.

12. An acoustic oscillation sensor (400) comprising the piezoelectric film integrated device according to any one of claims 1 to 11, wherein
the first monocrystalline piezoelectric film (15) outputs an acoustic oscillatory wave made up of at least one of a sonic wave and an ultrasonic wave, and
the second monocrystalline piezoelectric film (25) detects reflected waves of the acoustic oscillatory wave.

13. A method of manufacturing a piezoelectric film integrated device (100, 100a), the method comprising:
growing a first epitaxial growth film, including a first monocrystalline piezoelectric film (15), on a first crystal face of a growth substrate (11, 12);
growing a second epitaxial growth film, including a second monocrystalline piezoelectric film (25) having a crystal structure different from a crystal structure of the first monocrystalline piezoelectric film (15), on a second crystal face of another growth substrate; and
sticking the first epitaxial growth film peeled off from the growth substrate on a substrate (33) having an electrode and sticking the second epitaxial growth film peeled off from said another growth substrate on the substrate (33).

14. A method of manufacturing a piezoelectric film integrated device (200), the method comprising:
growing a first epitaxial growth film, including a first monocrystalline piezoelectric film (15), on a first crystal face of a substrate (33) having an electrode;
growing a second epitaxial growth film, including a second monocrystalline piezoelectric film (25) having a crystal structure different from a crystal structure of the first monocrystalline piezoelectric film (15), on a second crystal face of a growth substrate; and
sticking the second epitaxial growth film peeled off from the growth substrate on the electrode of the substrate (33).

15. A method of manufacturing a piezoelectric film integrated device (300), the method comprising:
growing a first epitaxial growth film, including a first monocrystalline piezoelectric film (15), on a first crystal face of a growth substrate;
growing a second epitaxial growth film, including a second monocrystalline piezoelectric film (25) having a crystal structure different from a crystal structure of the first monocrystalline piezoelectric film (15), on a second crystal face of a substrate (33) having an electrode; and
sticking the first epitaxial growth film peeled off from the growth substrate on the electrode of the substrate (33).

16. The method of manufacturing a piezoelectric film integrated device (100, 100a, 200, 300) according to any one of claims 13 to 15, wherein a crystal c-axis direction of the first monocrystalline piezoelectric film (15) and a crystal c-axis direction of the second monocrystalline piezoelectric film (25) are in a parallel relationship.

## Patentansprüche

1. Integrierte piezoelektrische Filmvorrichtung (100, 100a, 200, 300, 500) umfassend:
ein Substrat (33);
eine erste Elektrode (34a), die auf dem Substrat (33) vorgesehen ist;
eine zweite Elektrode (34b), die auf dem Substrat (33) vorgesehen ist;
einen ersten monokristallinen piezoelektrischen Film (15), der auf der ersten Elektrode (34a) vorgesehen ist;
einen zweiten monokristallinen piezoelektrischen Film (25), der auf der zweiten Elektrode (34b) vorgesehen ist und eine Kristallstruktur hat, die von einer Kristallstruktur des ersten monokristallinen piezoelektrischen Films (15) verschieden ist;
eine dritte Elektrode (16), die auf dem ersten monokristallinen piezoelektrischen Film (15) vorgesehen ist; und
eine vierte Elektrode (26), die auf dem zweiten monokristallinen piezoelektrischen Film (25) vorgesehen ist.

2. Integrierte piezoelektrische Filmvorrichtung (100, 100a, 200, 300, 500) nach Anspruch 1, wobei das Substrat (33) Vibrationsplatten (31) umfasst, die jeweils in Regionen unter dem ersten monokristallinen piezoelektrischen Film (15) und dem zweiten monokristallinen piezoelektrischen Film (25) vorgesehen sind.

3. Integrierte piezoelektrische Filmvorrichtung (100, 100a, 200, 300, 500) nach Anspruch 2, wobei
das Substrat (33) ein SOI-Substrat ist, das ein Si-Substrat (30), einen SiO₂-Teil (31) und einen monokristallinen Si-Teil (32) umfasst, und
die Vibrationsplatte (31) den SiO₂-Teil (31) und den monokristallinen Si-Teil (32) umfasst.

4. Integrierte piezoelektrische Filmvorrichtung (100, 100a, 200, 300, 500) nach einem der Ansprüche 1 bis 3, wobei
der erste monokristalline piezoelektrische Film (15) ein monokristalliner PZT-Film, ein monokristalliner KNN-Film oder ein monokristalliner Bariumtitanatfilm ist, und
der zweite monokristalline piezoelektrische Film (25) ein monokristalliner AIN-Film, ein monokristalliner Lithiumtantalatfilm oder ein monokristalliner Lithiumniobatfilm ist.

5. Integrierte piezoelektrische Filmvorrichtung (100, 100a, 200, 300, 500) nach einem der Ansprüche 1 bis 4, wobei der erste monokristalline piezoelektrische Film (15) ein epitaktischer Wachstumsfilm mit einer (001)-Oberfläche als eine Kristallfläche parallel zu einer Oberfläche der ersten Elektrode (34a) ist.

6. Integrierte piezoelektrische Filmvorrichtung (100, 100a, 200, 300, 500) nach einem der Ansprüche 1 bis 4, wobei der erste monokristalline piezoelektrische Film (15) ein epitaktischer Wachstumsfilm mit einer (001)-Oberfläche als eine Kristallfläche parallel zu einer Oberfläche der ersten Elektrode (34a) ist, der auf der Oberfläche der ersten Elektrode (34a) befestigt ist.

7. Integrierte piezoelektrische Filmvorrichtung (200, 300) nach einem der Ansprüche 1 bis 4, ferner umfassend einen SRO-Film, der auf der ersten Elektrode (34a) gebildet ist,
wobei der erste monokristalline piezoelektrische Film (15) ein epitaktischer Wachstumsfilm mit einer (001)-Oberfläche als eine Kristallfläche parallel zu einer Oberfläche des SRO-Films ist, der auf der Oberfläche des SRO-Films gebildet ist.

8. Integrierte piezoelektrische Filmvorrichtung (100, 100a, 200, 300, 500) nach einem der Ansprüche 1 bis 7, wobei der zweite monokristalline piezoelektrische Film (25) ein epitaktischer Wachstumsfilm mit einer (0001)-Oberfläche als eine Kristallfläche parallel zu einer Oberfläche der zweiten Elektrode (34b) ist.

9. Integrierte piezoelektrische Filmvorrichtung (100, 100a, 200, 300, 500) nach einem der Ansprüche 1 bis 7, wobei der zweite monokristalline piezoelektrische Film (25) ein epitaktischer Wachstumsfilm mit einer (0001)-Oberfläche als eine Kristallfläche parallel zu einer Oberfläche der zweiten Elektrode (34b) ist, der auf der Oberfläche der zweiten Elektrode (34b) befestigt ist.

10. Integrierte piezoelektrische Filmvorrichtung (200, 300) nach einem der Ansprüche 1 bis 6, ferner umfassend einen SRO-Film, der auf der zweiten Elektrode (34b) gebildet ist,
wobei der zweite monokristalline piezoelektrische Film (25) ein epitaktischer Wachstumsfilm mit einer (0001)-Oberfläche als eine Kristallfläche parallel zu einer Oberfläche des SRO-Films ist, der auf der Oberfläche des SRO-Films gebildet ist.

11. Integrierte piezoelektrische Filmvorrichtung (100, 100a, 200, 300, 500) nach einem der Ansprüche 1 bis 10, wobei eine c-Achsen-Kristallrichtung des ersten monokristallinen piezoelektrischen Films (15) und eine c-Achsen-Kristallrichtung des zweiten monokristallinen piezoelektrischen Films (25) in einem parallelen Verhältnis zueinander sind.

12. Akustischer Oszillationssensor (400), umfassend die integrierte piezoelektrische Filmvorrichtung nach einem der Ansprüche 1 bis 11, wobei
der erste monokristalline piezoelektrische Film (15) eine akustische Oszillationswelle ausgibt, die aus einer Schallwelle und/oder einer Ultraschallwelle gebildet ist, und
der zweite monokristalline piezoelektrische Film (25) reflektierte Wellen der akustischen Oszillationswelle detektiert.

13. Verfahren zur Herstellung einer integrierten piezoelektrischen Filmvorrichtung (100, 100a), wobei das Verfahren umfasst:
Aufwachsen eines ersten epitaktischen Wachstumsfilms, der einen ersten monokristallinen piezoelektrischen Film (15) umfasst, auf einer ersten Kristallfläche eines Wachstumssubstrats (11, 12);
Aufwachsen eines zweiten epitaktischen Wachstumsfilms, der einen zweiten monokristallinen piezoelektrischen Film (25) mit einer Kristallstruktur umfasst, die von einer Kristallstruktur des ersten monokristallinen piezoelektrischen Films (15) verschieden ist, auf einer zweiten Kristallfläche eines anderen Wachstumssubstrats; und
Befestigen des ersten epitaktischen Wachstumsfilms, der von dem Wachstumssubstrat abgeschält ist, auf einem Substrat (33) mit einer Elektrode, und Befestigen des zweiten epitaktischen Wachstumsfilms, der von dem anderen Wachstumssubstrat abgeschält ist, auf dem Substrat (33).

14. Verfahren zur Herstellung einer integrierten piezoelektrischen Filmvorrichtung (200), wobei das Verfahren umfasst:
Aufwachsen eines ersten epitaktischen Wachstumsfilms, der einen ersten monokristallinen piezoelektrischen Film (15) umfasst, auf einer ersten Kristallfläche eines Substrats (33) mit einer Elektrode;
Aufwachsen eines zweiten epitaktischen Wachstumsfilm, der einen zweiten monokristallinen piezoelektrischen Film (25) mit einer Kristallstruktur umfasst, die von einer Kristallstruktur des ersten monokristallinen piezoelektrischen Films (15) verschieden ist, auf einer zweiten Kristallfläche eines Wachstumssubstrats; und
Befestigen des zweiten epitaktischen Wachstumsfilm, der von dem Wachstumssubstrats abgeschält ist, auf der Elektrode des Substrats (33).

15. Verfahren zur Herstellung einer integrierten piezoelektrischen Filmvorrichtung (300), wobei das Verfahren umfasst:
Aufwachsen eines ersten epitaktischen Wachstumsfilms, der einen ersten monokristallinen piezoelektrischen Film (15) umfasst, auf einer ersten Kristallfläche eines Wachstumssubstrats;
Aufwachsen eines zweiten epitaktischen Wachstumsfilms, der einen zweiten monokristallinen piezoelektrischen Film (25) mit einer Kristallstruktur umfasst, die von einer Kristallstruktur des ersten monokristallinen piezoelektrischen Films (15) verschieden ist, auf einer zweiten Kristallfläche eines Substrats (33) mit einer Elektrode; und
Befestigen des ersten epitaktischen Wachstumsfilms, der von dem Wachstumssubstrat abgeschält ist, auf der Elektrode des Substrats (33).

16. Verfahren zur Herstellung einer integrierten piezoelektrischen Filmvorrichtung (100, 100a, 200, 300) nach einem der Ansprüche 13 bis 15, wobei eine c-Achsen-Kristallrichtung des ersten monokristallinen piezoelektrischen Films (15) und eine c-Achsen-Kristallrichtung des zweiten monokristallinen piezoelektrischen Films (25) in einem parallelen Verhältnis zueinander sind.

## Revendications

1. Dispositif intégré à film piézoélectrique (100, 100a, 200, 300, 500) comprenant :
un substrat (33) ;
une première électrode (34a) ménagée sur le substrat (33) ;
une deuxième électrode (34b) ménagée sur le substrat (33) ;
un premier film piézoélectrique monocristallin (15) ménagé sur la première électrode (34a) ;
un deuxième film piézoélectrique monocristallin (25) ménagé sur la deuxième électrode (34b) et présentant une structure cristalline différente d'une structure cristalline du premier film piézoélectrique monocristallin (15) ;
une troisième électrode (16) ménagée sur le premier film piézoélectrique monocristallin (15) ; et
une quatrième électrode (26) ménagée sur le deuxième film piézoélectrique monocristallin (25).

2. Dispositif intégré à film piézoélectrique (100, 100a, 200, 300, 500) selon la revendication 1, dans lequel le substrat (33) comporte des plaques vibrantes (31) ménagées respectivement dans des régions sous le premier film piézoélectrique monocristallin (15) et le deuxième film piézoélectrique monocristallin (25).

3. Dispositif intégré à film piézoélectrique (100, 100a, 200, 300, 500) selon la revendication 2, dans lequel
le substrat (33) est un substrat SOI qui comporte un substrat Si, une partie en SiO₂ (31) et une partie en Si monocristallin (32), et
la plaque vibrante (31) comporte la partie en SiO₂ (31) et la partie en Si monocristallin (32).

4. Dispositif intégré à film piézoélectrique (100, 100a, 200, 300, 500) selon l'une quelconque des revendications 1 à 3, dans lequel
le premier film piézoélectrique monocristallin (15) est un film en PZT monocristallin, un film en KNN monocristallin ou un film en titanate de baryum monocristallin, et
le deuxième film piézoélectrique monocristallin (25) est un film en AIN monocristallin, un film en tantalate de lithium monocristallin ou un film en niobate de lithium monocristallin.

5. Dispositif intégré à film piézoélectrique (100, 100a, 200, 300, 500) selon l'une quelconque des revendications 1 à 4, dans lequel le premier film piézoélectrique monocristallin (15) est un film de croissance épitaxiale présentant une surface (001) en tant que face cristalline parallèle à une surface de la première électrode (34a).

6. Dispositif intégré à film piézoélectrique (100, 100a, 200, 300, 500) selon l'une quelconque des revendications 1 à 4, dans lequel le premier film piézoélectrique monocristallin (15) est un film de croissance épitaxiale présentant une surface (001) en tant que face cristalline parallèle à une surface de la première électrode (34a) et collée sur la surface de la première électrode (34a).

7. Dispositif intégré à film piézoélectrique (200, 300) selon l'une quelconque des revendications 1 à 4, comprenant en outre un film en SRO formé sur la première électrode (34a),
dans lequel le premier film piézoélectrique monocristallin (15) est un film de croissance épitaxiale présentant une surface (001) en tant que face cristalline parallèle à une surface du film en SRO et formée sur la surface du film en SRO.

8. Dispositif intégré à film piézoélectrique (100, 100a, 200, 300, 500) selon l'une quelconque des revendications 1 à 7, dans lequel le deuxième film piézoélectrique monocristallin (25) est un film de croissance épitaxiale présentant une surface (0001) en tant que face cristalline parallèle à une surface de la deuxième électrode (34b).

9. Dispositif intégré à film piézoélectrique (100, 100a, 200, 300, 500) selon l'une quelconque des revendications 1 à 7, dans lequel le deuxième film piézoélectrique monocristallin (25) est un film de croissance épitaxiale présentant une surface (0001) en tant que face cristalline parallèle à une surface de la deuxième électrode (34b) et collée sur la surface de la deuxième électrode (34b).

10. Dispositif intégré à film piézoélectrique (200, 300) selon l'une quelconque des revendications 1 à 6, comprenant en outre un film en SRO formé sur la deuxième électrode (34b),
dans lequel le deuxième film piézoélectrique monocristallin (25) est un film de croissance épitaxiale présentant une surface (0001) en tant que face cristalline parallèle à une surface du film en SRO et formée sur la surface du film en SRO.

11. Dispositif intégré à film piézoélectrique (100, 100a, 200, 300, 500) selon l'une quelconque des revendications 1 à 10, dans lequel une direction d'axe c cristallin du premier film piézoélectrique monocristallin (15) et une direction d'axe c cristallin du deuxième film piézoélectrique monocristallin (25) sont parallèles l'une à l'autre.

12. Capteur d'oscillation acoustique (400) comprenant le dispositif intégré à film piézoélectrique selon l'une quelconque des revendications 1 à 11, dans lequel
le premier film piézoélectrique monocristallin (15) délivre en sortie une onde oscillatoire acoustique constituée d'au moins l'une parmi une onde sonore et une onde ultrasonore, et
le deuxième film piézoélectrique monocristallin (25) détecte des ondes réfléchies de l'onde oscillatoire acoustique.

13. Procédé de fabrication d'un dispositif intégré à film piézoélectrique (100, 100a), le procédé comprenant :
la croissance d'un premier film de croissance épitaxiale, comportant un premier film piézoélectrique monocristallin (15), sur une première face cristalline d'un substrat de croissance (11, 12) ;
la croissance d'un deuxième film de croissance épitaxiale, comportant un deuxième film piézoélectrique monocristallin (25) présentant une structure cristalline différente d'une structure cristalline du premier film piézoélectrique monocristallin (15), sur une deuxième face cristalline d'un autre substrat de croissance ; et
le collage du premier film de croissance épitaxiale décollé du substrat de croissance sur un substrat (33) présentant une électrode et le collage du deuxième film de croissance épitaxiale décollé dudit autre substrat de croissance sur le substrat (33).

14. Procédé de fabrication d'un dispositif intégré à film piézoélectrique (200), le procédé comprenant :
la croissance d'un premier film de croissance épitaxiale, comportant un premier film piézoélectrique monocristallin (15), sur une première face cristalline d'un substrat (33) présentant une électrode ;
la croissance d'un deuxième film de croissance épitaxiale, comportant un deuxième film piézoélectrique monocristallin (25) présentant une structure cristalline différente d'une structure cristalline du premier film piézoélectrique monocristallin (15), sur une deuxième face cristalline d'un substrat de croissance ; et
le collage du deuxième film de croissance épitaxiale décollé du substrat de croissance sur l'électrode du substrat (33).

15. Procédé de fabrication d'un dispositif intégré à film piézoélectrique (300), le procédé comprenant :
la croissance d'un premier film de croissance épitaxiale, comportant un premier film piézoélectrique monocristallin (15), sur une première face cristalline d'un substrat de croissance ;
la croissance d'un deuxième film de croissance épitaxiale, comportant un deuxième film piézoélectrique monocristallin (25) présentant une structure cristalline différente d'une structure cristalline du premier film piézoélectrique monocristallin (15), sur une deuxième face cristalline d'un substrat (33) présentant une électrode ; et
le collage du premier film de croissance épitaxiale décollé du substrat de croissance sur l'électrode du substrat (33).

16. Procédé de fabrication d'un dispositif intégré à film piézoélectrique (100, 100a, 200, 300) selon l'une quelconque des revendications 13 à 15, dans lequel une direction d'axe c cristallin du premier film piézoélectrique monocristallin (15) et une direction d'axe c cristallin du deuxième film piézoélectrique monocristallin (25) sont parallèles l'une à l'autre.
